# EUROPEAN PATENT SPECIFICATION

(11) **EP 1 940 209 B1**
(45) Date of publication and mention of the grant of the patent: **02.06.2010**
(21) Application number: 08075294.2
(22) Date of filing: 01.07.1999
(51) Int. Cl.: H05K 3/38, H05K 3/28, H05K 3/46

(54) **Printed wiring board and method of producing the same**
Leiterplatte und Herstellungsverfahren dafür
Carte de circuit imprimé et son procédé de fabrication

(30) Priority: 08.07.1998 JP 20867198; 30.04.1999 JP 12392699; 20.05.1999 JP 13953999
(43) Date of publication of application: 02.07.2008
(62) Divisional of application: 99926882.4
(73) Proprietor: IBIDEN CO., LTD., Ogaki-shi Gifu ken 503-0917 (JP)
(72) Inventor: En, Hontin, Ibi-gun, Gifu 501-0695 (JP); Zhong, Hui, Ibi-gun, Gifu 501-0695 (JP)
(74) Representative: Hill, Christopher Michael

(56) References cited:
- EP-A- 0 743 812
- EP-A- 0 844 809
- US-A- 5 532 094

## Description

### TECHNICAL FIELD

This invention relates to a method of producing a printed wiring board, and more particularly to a printed wiring board capable of improving an adhesion property and a strength among conductor circuit for solder pad, solder resist layer and solder bump.

### BACKGROUND ART

Recently, so-called build-up multilayer wiring board is considerably noticed from a viewpoint of a demand for high densification of multilayer wiring boards. Such a build-up multilayer wiring board is produced by a method disclosed, for example, in JP-B-4-55555.

According to this method, an insulating material made from a photosensitive adhesive for electroless plating is applied onto a core substrate, dried, exposed to a light and developed to form an interlaminar insulating resin layer having an opening for a via-hole. Then, the surface of the interlaminar insulating resin layer is roughened by treating with an oxidizing agent or the like and a plating resist is disposed on the roughened surface, and thereafter non-resist forming portions are subjected to an electroless plating to form two-layer conductor circuit pattern including a via-hole. These steps are repeated several times to obtain a multilayered build-up wiring board.

In such a printed wiring board, solder bumps are arranged on respective conductor circuits for solder pads as a surface layer, and the board is connected to an IC chip through the solder bumps. In order to protect the conductor circuits for the solder pads as the surface layer and prevent the fusion between the solder bumps, a solder resist layer is disposed in the printed wiring board.

Furthermore, in order to enhance the adhesion of the solder resist layer to the conductor circuit for the solder pad in the printed wiring board, the surfaces of the conductor circuits for the solder pads are subjected to a roughening treatment. As the roughening treatment of the conductor circuit, there are used graphitization-reduction treatment, etching with sulfuric acid-hydrogen peroxide, copper-nickel-phosphorus needle-shaped alloy plating and the like.

Other methods are known from EP-A-0 844 809 and US-A-5 532 094.

### PROBLEMS TO BE SOLVED BY THE INVENTION

Recently, a technique of using a fine wiring is noticed as a conductor pattern in the printed wiring board because a high densification of the conductor circuits can be attained by such a fine wiring.

In such finely wired conductor circuits, however, a contact area between the conductor circuit and the solder resist layer becomes considerably small and hence the adhesion property between the conductor circuit and the solder resist layer lowers. Particularly, when the conductor circuits are arranged at a coarse state in the surface layer of the printed wiring board, the adhesion property between the conductor circuit and the solder resist layer more lowers.

And also, the strength of the solder bump is difficult to be maintained in the finely wired conductor circuits for the solder pads, and hence there may be caused the dropping-off of the solder bump.

Furthermore, the inventors have confirmed that if the roughened surface of the finely wired conductor circuit is deteriorated by oxidation, corrosion or the like, the adhesion property to the solder resist layer is considerably lowered. Particularly, when the conductor circuits are arranged at a coarse state in the surface layer of the printed wiring board, the adhesion property between the conductor circuit and the solder resist layer more lowers.

It is, therefore, an object of the invention to provide a printed wiring board in which the adhesion property between the finely wired conductor circuit and the solder resist layer is enhanced and these conductor circuits are strongly adhered to the solder resist layer without peeling even in solder bump-forming portions to cause no bad continuity in the solder bump-forming portions.

It is another object of the invention to provide a printed wiring board capable of holding a strength of an adhered portion between the conductor circuit for solder pad and the solder bump at a higher state and preventing the dropping-off of the solder bump.

### DISCLOSURE OF THE INVENTION

The invention lies in a method of producing a printed wiring board as defined in claim 1.

The inventors have made various studies with respect to the method of roughening the surface of the conductor circuit for solder pad in order to improve the adhesion property and strength between the surface layer of the multilayer printed wiring board and the solder resist layer and the adhesion property and strength between the surface layer of the multilayer printed wiring board and the solder pad. Particularly, the inventors have studied a graphitization-reduction treatment, an etching treatment with sulfuric acid-hydrogen peroxide or the like, a copper-nickel-phosphorus needle-shaped alloy plating and the like for demands to enhance the adhesion property and strength between the conductor circuit formed at fine wiring of not more than 50 µm and the solder resist layer and the adhesion property and strength between the conductor circuit and the solder bump, especially a demand for enhancing adhesion strength to prevent peelings and dropping-off of the solder pad and solder bump after the reliability test.

As a result, it has unexpectedly confirmed that the graphitization-reduction treatment, the etching treatment with sulfuric acid-hydrogen peroxide and the like are unsuitable as the roughening treatment of the conductor circuit for solder pad with finer wiring. In case of the graphitization-reduction treatment, the etching treatment with sulfuric acid-hydrogen peroxide and the like, if the wiring density is made coarse with the fine wiring of not more than 50 µm, it has been confirmed that the contact area between the conductor circuit and the solder resist layer is made small by the convex portion formed on the roughened surface and the adhesion force of the solder resist layer can not be improved. Particularly, it has been confirmed that the solder resist layer is peeled off in the coarse portion of the wiring density under heat cycle condition. And also, the noble metal layer is peeled off in the solder pad, or cracking is caused to induce the dropping-off of the solder bump by the graphitization-reduction treatment or the like.

Furthermore, it has been confirmed that the formation of the roughened layer through the copper-nickel-phosphorus needle-shaped alloy plating is excellent in the adhesion property between the conductor circuit and the solder resist layer and indicates sufficient adhesion force even in the fine wiring of not more than 50 µm, particularly a coarse portion of such a wiring. However, the roughened layer is formed by the plating, so that as the density of the fine wiring becomes high, the precipitated needle-shaped alloy stretches on the interlaminar resin insulating layer to connect the conductor circuits to each other to thereby cause a short-circuit.

In the formation of the roughened layer through the copper-nickel-phosphorus needle-shaped alloy plating, it is necessary to conduct a severe maintenance and control of the plating solution in order to prevent the abnormal precipitation due to the stretching of the needle-shaped alloy.

And also, the solder resist layer made of a resin is removed by light exposure and development in the portions forming the solder bumps. In this case, since needle projections crowd to each other in the roughened layer made of the copper-nickel-phosphorus needle-shaped alloy, the distance between the projections is narrow, so that it has been confirmed that when the solder resist layer is removed by the light exposure and development to form portions forming the solder bumps, an oxidizing agent solution or an alkali solution for removing the developing solution or residual resin does not flow in an opening portion and hence the resin retains between the projections to leave an organic residue of the solder resist forming resin in the bottom of the opening portion. Such an organic residue may cause bad continuity or wiring breakage between the conductor circuit for solder pad in the opening portion and the metal beneath the solder bump. Further, the organic residue does not conduct the formation of the noble metal layer in the solder pad or causes the poor formation thereof to thereby lower the strength between the solder pad and the conductor circuit for the solder pad.

Under the above knowledge, the inventors have made further studies with respect to the other roughening treatment. Consequently, it has been found out that the roughened surface formed by treating the surface of the conductor circuit with an etching solution containing a copper(II) complex and an organic acid is excellent in the adhesion property to the solder resist forming resin and the adhesion property to the metal beneath the solder bump and is very suitable for the formation of the solder bump and as a result, the invention has been accomplished.

In the printed wiring board according to the invention, the roughened surface having a given roughened shape as formed by the above etching solution is formed on the conductor circuit and the solder resist layer is arranged through such a roughened surface. The roughened surface is formed on the conductor circuits having a high wiring density with finer wiring of not more than 50 µm without causing the bad continuity as in the copper-nickel-phosphorus needle-shaped alloy plating.

And also, the roughened surface is excellent in the adhesion property to the solder resist layer and can ensure the sufficient adhesion property between the conductor circuit and the solder resist layer when the solder resist layer is removed in the portion forming the solder bump to make small the contact area between the conductor circuit and the solder resist layer, or even in the printed wiring board having a coarse state of the wiring density with fine wiring.

Further, when the solder resist layer is removed to form an opening portion for the formation of the solder bump, the resin residue is less on the roughened surface, so that the roughened surface is excellent in the adhesion property to the metal beneath the solder bump and does not cause the bad continuity in the portion forming the solder bump.

On the other hand, the inventors have detailedly studied the roughened surface of the conductor circuit for the solder pad in order to enhance the strength of the solder bump.

As a result, the inventors have found that the above roughened surface is considerably degraded by oxidation, corrosion or the like. According to the inventors' studies, it has been confirmed that as the degradation of the roughened surface occurs, the strength of the uneven portion on the surface considerably lowers and the uneven portion is dissolved by a solvent such as an acid, an alkali or the like. Such a degradation of the roughened surface considerably weakens the adhesion strength between the solder resist layer and the roughened surface or between the roughened surface and the metal beneath the solder bump and causes the peeling therebetween.

Under the above knowledge, the inventors have made further studies with respect to the treatment of the roughened surface in order to increase the adhesion strength between the solder resist layer and the roughened surface or between the roughened surface and the metal beneath the solder bump and prevent the peeling therebetween.

Consequently, the inventors have found out that the strength of the solder bump is considerably increased in the printed wiring board produced by covering the roughened surface with a metal layer of at least one metal selected from the group consisting of titanium, zinc, iron, indium, thallium, cobalt, nickel, tin, lead, bismuth and a noble metal and arranging the solder resist layer on the metal layer and as a result, the invention has been accomplished.

In the invention, the metal layer prevents the oxidation, corrosion or the like of the roughened surface and also prevents the surface degradation of the roughened surface. And also, according to the invention, the metal layer protects the uneven portions of the roughened surface against the solvent such as acid, alkali or the like and prevents the dissolution of the uneven portions in the roughened surface even when the roughened surface is immersed in such a solvent.

According to the invention, the metal layer prevents the lowering of the strength of the roughened surface and also the roughened surface covered with the metal layer holds its shape and strength, so that there can be eliminated the peeling between the roughened surface and the solder resist layer, no formation or poor formation of the metal layer in the solder pad.

In the roughened surface covered with the metal layer, the surface degradation of the roughened surface is not caused as compared with the roughened surface not covered with the metal layer in the arrangement of the solder resist layer and the solder bump, so that the shape of the roughened layer becomes uniform and the oxidation or dissolution of the roughened surface through chemicals can be prevented.

In the printed wiring board using such a roughened surface, the adhesion strength between the conductor circuit for solder pad and the solder bump is considerably improved. For example, a shear strength of the solder bump is improved by at least 10%. And also, even in the reliability test, there are not caused the peeling of the solder resist layer, peeling of the metal layer, cracking and occurrence of dropping-off of the solder bump.

In the printed wiring board according to the invention, the shape and strength having excellent adhesion property to the solder resist layer and adhesion property to the metal beneath the solder bump are maintained by covering the roughened surface of the conductor circuit for solder pad with the metal layer, so that the strength of the solder bump is considerably increased and the dropping-off of the solder bump can be prevented.

Furthermore, the inventors have made various studies and found that the roughened surface formed on the finely wired conductor circuit for solder pad is deteriorated by oxidation, corrosion or the like, whereby the adhesion property between the solder resist layer and the conductor circuit for solder pad formed by the graphitization-reduction treatment, etching treatment with sulfuric acid-hydrogen peroxide or the like is considerably lowered. When the solder resist forming resin is applied to the conductor circuit for the solder pad, if the conductor circuit is deteriorated, since the wettability of the solder resist forming resin differs, the adhesion property of the solder resist layer lowers at the contact surface between the conductor circuit and the solder resist layer. And also, when the solder resist layer arranged on the roughened surface of the conductor circuit for solder pad is opened, sine the conductor circuit is deteriorated, the conductor circuit is dissolved due to exposure and hence the adhesion property between the conductor circuit for solder pad and the solder pad lowers and the strength of the solder bump lowers.

Under the above knowledge, the inventors have made various means for controlling the deterioration of the conductor circuit for solder pad. Consequently, it has been found out that when a rust proof layer is formed on the conductor circuit after the formation of the roughened surface on the conductor circuit and then the solder resist layer is arranged thereon and an opening for the solder pad is formed, the deterioration of the conductor circuit can be prevented and the contact surface to the solder resist layer and the roughened surface of the conductor circuit on the opening surface are maintained and hence the adhesion property between the conductor circuit for solder pad and the solder resist layer or between the solder pad and the conductor circuit for solder pad is held and the strengths of the solder resist layer and the solder bump are increased and as a result, the invention has been accomplished.

According to the invention, the surface layer of the roughened surface and the metal state of the conductor circuit for solder pad as a whole can be prevented from deteriorating due to oxidation, corrosion or the like by forming the rust proof layer on the roughened surface. In the formation of the solder resist layer, the difference in the wettability to the conductor circuit for solder pad is removed and there is not caused the peeling between the conductor circuit for solder pad and the solder resist layer resulted from the difference of the wettability.

Since the rust proof layer on the conductor circuit for solder pad prevents the deterioration of the conductor circuit, according to the invention, even if the opening for the solder pad is formed on the solder resist layer, the elution of the conductor circuit is eliminated and the roughened surface having a very good adhesion property to the solder pad can be held.

On the other hand, the inventors have made various means for more improving the strength of the solder pad.

Consequently, the inventors have found out that in the printed wiring board wherein a metal layer for rust proof layer made of at least one metal selected from the group consisting of titanium, zinc, iron, indium, thallium, cobalt, nickel, tin, lead, bismuth and a noble metal is formed on the roughened surface of the conductor circuit for solder pad and a rust proof layer is formed on the metal layer and the solder resist layer is arranged on the rust proof layer and an opening portion for solder body is formed, the shape of the roughened surface having an excellent adhesion property between the solder resist layer and the solder pad is maintained and also the strength of the solder pad is more improved on the roughened surface exposed to the opening portion and as a result, the invention has been accomplished.

The roughened surface covered with the metal layer for the rust proof layer can prevent the deterioration of the roughened surface due to the oxidation, corrosion or the like and the dissolution of uneven surface in the immersion into acid or alkali solution. Therefore, the roughened surface is a uniform shape and holds the strength, so that there is not caused the peeling of the solder resist layer and the non-formation of the metal layer in the solder pad and the dropping-off of the solder bump can be prevented.

And also, it has been found that the above roughened surface does not cause the bad continuity due to the resin residue in the formation of the opening portion in the solder resist layer. Because, the deterioration is not caused by covering with the metal layer for the rust proof layer and the wettability on the roughened surface becomes uniform and the organic residue of the resin itself is not left.

Furthermore, when the solder resist layer is removed to form the opening portion for the formation of solder bump, the roughened surface does not cause the resin residue thereon and is excellent in the adhesion property to the metal beneath the solder bump and does not cause the bad continuity in the portions forming the solder bumps.

Moreover, the roughened surface covered with the metal layer for the rust proof layer uniformly holds the shape of the roughened surface as compared with the case of forming the solder resist layer and solder bumps on the roughened surface not covered with the metal layer for the rust proof layer, maintains the shape of the roughened surface and improves the strength of the resulting solder bump, which can prevent the oxidation or dissolution of the roughened surface through chemicals and the shear strength of the solder bump is improved by at least 10%. And also, even in the reliability test, there are not caused the peeling of the solder resist layer, peeling of the metal layer, cracking and occurrence of dropping-off.

In the printed wiring board according to the invention, water and extra chemicals remaining on the roughened surface are removed by the rust proof layer, so that the swelling or peeling of the solder resist layer is not caused even after the reliability test, so that the connection reliability is improved. Particularly, when the roughened surface is formed by etching, residual water is easily left in the uneven portion and is difficult to be removed even by a heat treatment, so that the use of the rust proof layer according to the invention is effective.

The roughened surface of the conductor circuit for solder pad in the printed wiring board according to the invention is protected with the rust proof layer, so that the deterioration of the conductor circuit for solder pad is prevented and the shape of the roughened surface having excellent adhesion properties to the solder resist layer and the solder pad is maintained and hence the adhesion property between the solder resist layer and the conductor circuit for solder pad having a coarse wiring state with fine wiring is increased and the conductor circuit and the solder resist layer are strongly adhered to each other without peeling even in the portions forming the solder bumps and the bad continuity is not caused in the portion forming the solder bump.

In the printed wiring board according to the invention, the roughened surface of the conductor circuit for solder pad is covered with a given metal and protected with the rust proof layer, so that even when the solder pad is applied after a part of the solder resist layer is opened, the surface of the conductor circuit for solder pad maintains the shape having an excellent adhesion property to the solder pad and also the resin resulted from the solder resist layer is not left, so that the adhesion properties and strengths between the conductor circuit for solder pad and the solder resist layer and between the conductor circuit for solder pad and the solder pad are improved and the solder bump having an excellent adhesion property to the metal beneath the solder bump is formed.

### BRIEF DESCRIPTION OF THE DRAWINGS

Fig. 1 is a microphotograph illustrating a first embodiment of the roughened surface according to the invention.
Fig. 2 is a microphotograph illustrating a second embodiment of the roughened surface according to the invention.
Fig. 3 is a microphotograph illustrating a third embodiment of the roughened surface according to the invention.
Fig. 4 is a diagrammatic view of the roughened surface according to the invention.
Fig. 5 is a diagrammatically section view of the roughened surface according to the invention.
Fig. 6 is a diagrammatically section view of the roughened surface according to the invention.
Fig. 7 is a diagrammatically section view of the roughened surface according to the invention.
Fig. 8 is a diagrammatically section view of the roughened surface according to the invention.
Fig. 9 is a diagrammatically section view of the other roughened surface according to the invention.
Fig. 10 is a diagrammatically section view of the other roughened surface according to the invention.
Fig. 11 is a diagrammatically section view of the other roughened surface according to the invention.
Fig. 12 is a diagrammatically section view of the other roughened surface according to the invention.
Fig. 13 is a diagrammatically section view of an embodiment of the roughened surface provided with a rust proof layer according to the invention.
Fig. 14 is a diagrammatically section view of another embodiment of the roughened surface provided with a rust proof layer according to the invention.
Fig. 15 is a production step view in an embodiment of the printed wiring board according to the invention.
Fig. 16 is a production step view in an embodiment of the printed wiring board according to the invention.
Fig. 17 is a production step view in an embodiment of the printed wiring board according to the invention.
Fig. 18 is a production step view in an embodiment of the printed wiring board according to the invention.
Fig. 19 is a production step view in an embodiment of the printed wiring board according to the invention.
Fig. 20 is a production step view in an embodiment of the printed wiring board according to the invention.
Fig. 21 is a production step view in an embodiment of the printed wiring board according to the invention.
Fig. 22 is a production step view in an embodiment of the printed wiring board according to the invention.
Fig. 23 is a production step view in an embodiment of the printed wiring board according to the invention.
Fig. 24 is a production step view in an embodiment of the printed wiring board according to the invention.
Fig. 25 is a production step view in an embodiment of the printed wiring board according to the invention.
Fig. 26 is a production step view in an embodiment of the printed wiring board according to the invention.
Fig. 27 is a production step view in an embodiment of the printed wiring board according to the invention.
Fig. 28 is a production step view in an embodiment of the printed wiring board according to the invention.
Fig. 29 is a production step view in an embodiment of the printed wiring board according to the invention.
Fig. 30 is a production step view in an embodiment of the printed wiring board according to the invention.
Fig. 31 is a production step view in an embodiment of the printed wiring board according to the invention.
Fig. 32 is a production step view in an embodiment of the printed wiring board according to the invention.
Fig. 33 is a diagrammatically section view of another embodiment of the printed wiring board according to the invention.
Fig. 34 is a diagrammatically section view of the other embodiment of the printed wiring board according to the invention.
Fig. 35 is a diagrammatically partial section view of a still further embodiment of the printed wiring board according to the invention.

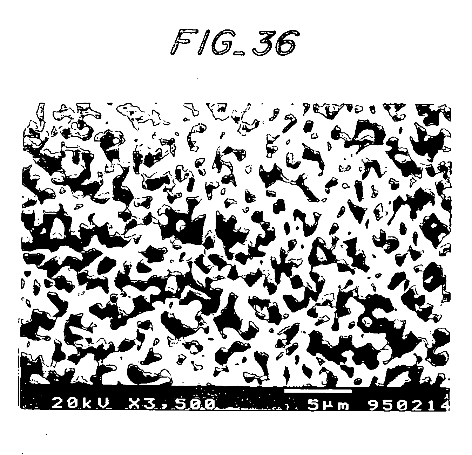

Fig. 36 is a microphotograph illustrating a roughened layer made of a needle-shaped alloy.

### BEST MODE FOR CARRYING OUT THE INVENTION

The invention will be described in detail with reference to the drawings.

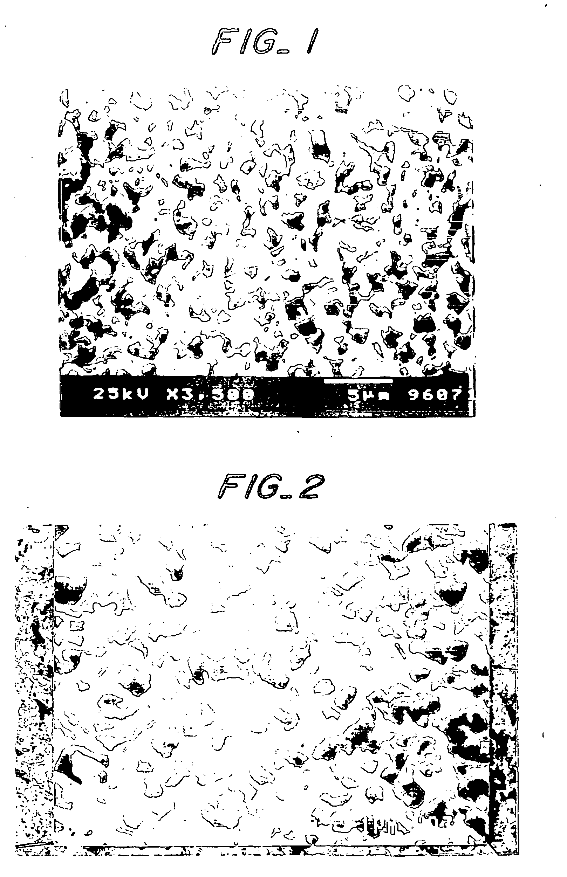

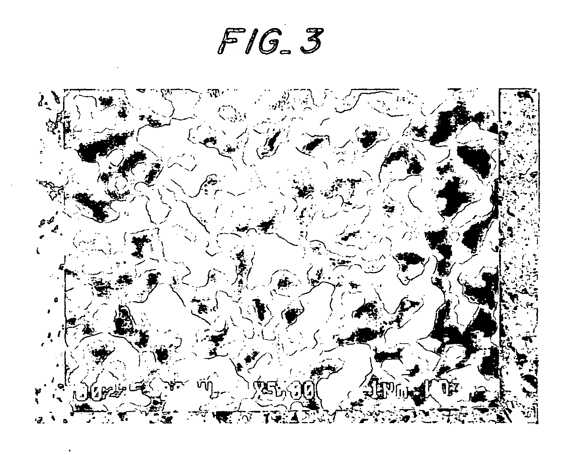

When the conductor circuit for solder pad is treated with an etching solution according to the invention, the surface is different from the case of needle-shaped alloy plating and is a roughened surface having anchor portions as shown in Figs. 1-8. Fig. 1 is a microphotograph illustrating a first embodiment of the roughened surface according to the invention. This is pictured obliquely from the roughened surface by means of an electron microscope. Fig. 2 is a microphotograph illustrating a second embodiment of the roughened surface according to the invention. This is also pictured likewise the case of Fig. 1 in a higher magnification. Fig. 3 is a microphotograph illustrating a third embodiment of the roughened surface according to the invention. This is pictured just above the roughened surface by means of an electron microscope in the same magnification as in Fig. 2.

In the printed wiring board according to the invention, a solder resist layer is arranged on the conductor circuit for solder pad through the roughened surface formed on the conductor circuit as shown by the above electron microphotograph.

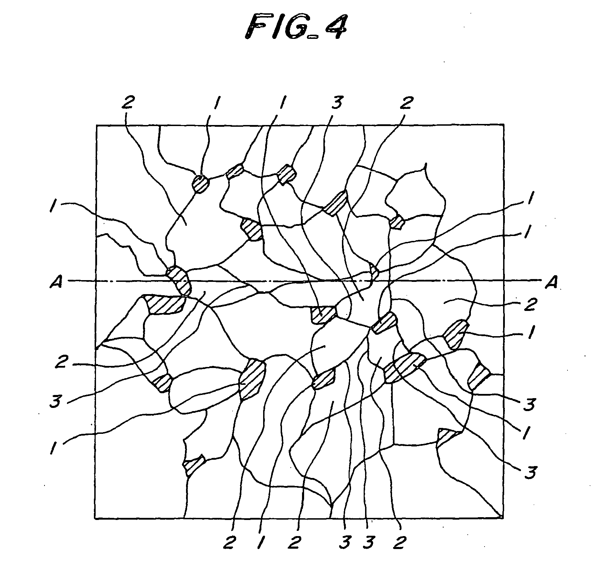

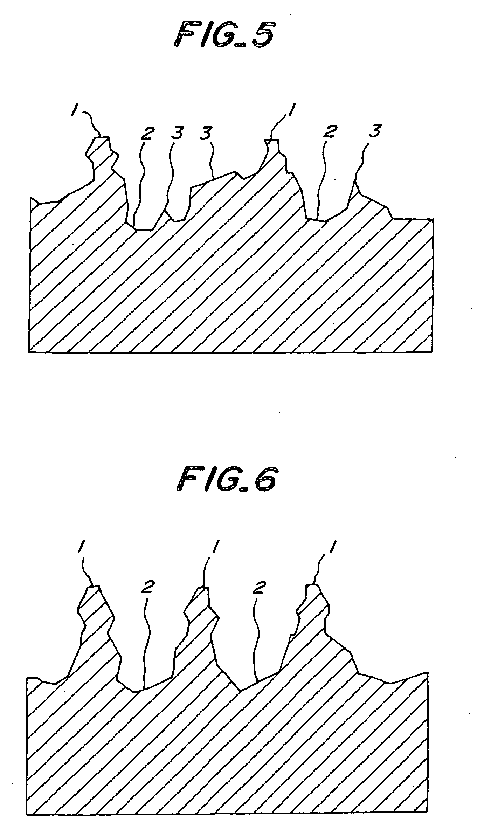

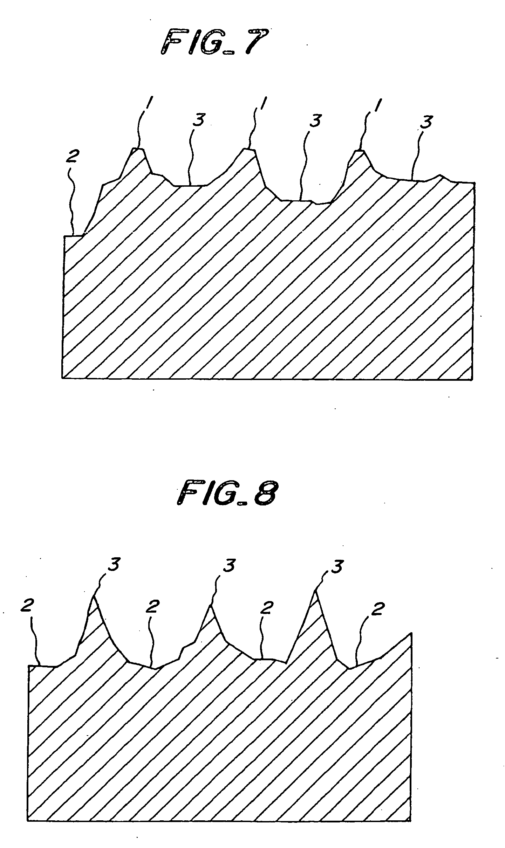

Figs. 4-8 are diagrammatic views of such a roughened surface. Fig. 4 is a plane view, Fig. 5 is a longitudinal section view along a line A-A of Fig. 4, Fig. 6 is a longitudinal section view cut between anchor portion and recess portion, Fig. 7 is a longitudinal section view illustrating ridgelines between anchor portions, and Fig. 8 is a longitudinal section view cut between ridgeline and recess portion.

As shown in Figs. 4 and 5, the roughened surface according to the invention has plural anchor portions 1, plural recess portions 2 and plural ridgelines 3 in which the anchor portions 1, recess portions 2 and ridgelines 3 are dispersed. As shown in Fig. 6, the recess portion 2 is formed between the anchor portion 1 and anchor portion 1 adjacent thereto. As shown in Fig. 7, the anchor portion 1 and another anchor portion 1 adjacent thereto are connected to each other through the ridgeline 3. The recess portion 2 is surrounded by the anchor portions 1 and the ridgelines 3 as shown in Figs. 6 and 8.

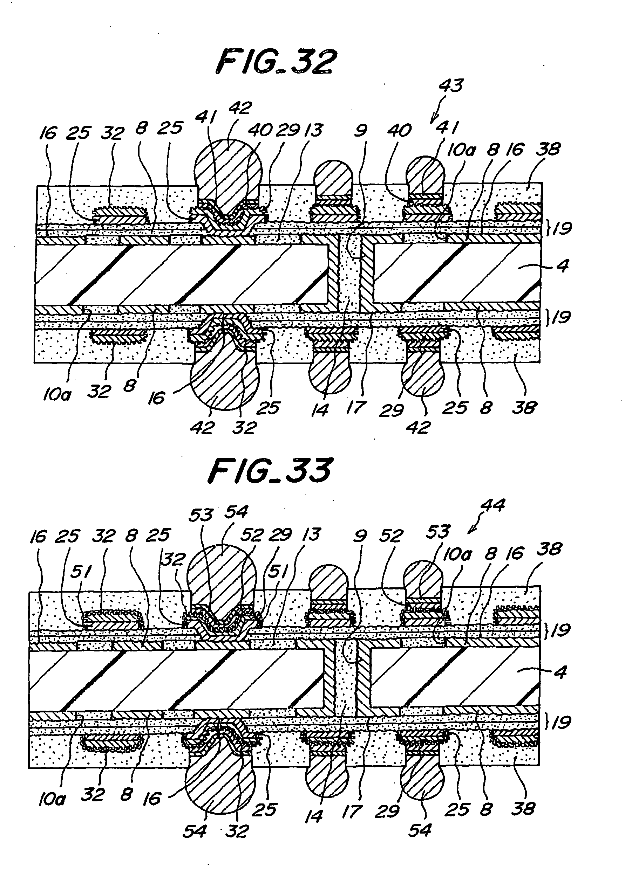

For the comparison, a microphotograph of a roughened layer made of the conventional needle-shaped alloy by plating is shown in Fig. 32. In the roughened layer shown by the electron microphotograph, needle-shaped alloys are overlapped with each other and a space is formed between the needle-shaped alloys. In the structure of such Cu-Ni-P needle-shaped alloy, needle projections crowd to each other, so that the distance between the projections is narrow and hence an oxidizing agent solution for removing the developing solution or residual resin is not flowed and the resin retains between the projections to cause resin residue.

On the contrary, the roughened surface according to the invention indicates a complicated uneven shape wherein the anchor portion is a highest portion and the recess portion is formed in lowest portion surrounding the anchor portion and the anchor portion and another anchor portion adjacent thereto are connected each other through the ridgeline lower than the anchor portion but higher than the recess portion. In the roughened surface having such a complicated uneven shape, the anchor portions enter into the solder resist layer to strongly bond the conductor circuit to the solder resist layer, so that the peeling between the conductor circuit and the solder resist layer is not caused in the portion forming the solder bump, particularly even at a state that the wiring density with fine wiring is coarse. And also, since the roughened surface is excellent in the affinity to the plating solution, the plated film is penetrated into the recess portions of the roughened surface to adhere to the anchor portions of the roughened surface, so that the anchor portions dig into the metal beneath solder bump and hence the adhesion property between the conductor circuit and the solder bump is not lowered.

In such a roughened surface, the anchor portions do not crowd to each other and also the ridgelines connecting the anchor portions have a shape not obstructing the flow of the resin. In the roughened surface, therefore, the oxidizing agent solution for removing the developing solution or the resin residue is easily flowed between the recess portions or between the anchor portions and the solder resist forming resin hardly retains. For this end, the roughened surface according to the invention has no resin residue after the developing treatment and is excellent in the adhesion property to the metal beneath the solder bump.

Thus, the roughened surface according to the invention has an optimum shape of preventing the resin residue after the developing treatment while maintaining the adhesion property between the conductor circuit and the solder resist layer and the adhesion property between the conductor circuit and the metal beneath solder bump.

The roughened surface according to the invention can be formed by dropping off metal crystal particles from the surface of the conductor circuit with an etching solution containing a copper(II) complex and an organic acid. In the roughened surface, portions dropping off the metal crystal particles form the recess portions (concave parts). The recess portions can be formed in the shape corresponding to approximately polyhedral shape inherent to the metal crystal particle. In the invention, the term "approximately polyhedral shape" used herein means a polyhedron such as trihedron, tetrahedron, pentahedron, hexahedron or the like and a combination of two or more of these polyhedrons. Such a recess portion can prevent the resin residue after the developing treatment.

And also, the anchor portions of the roughened surface can be formed as portions left by dropping off the metal crystal particles. The thus formed anchor portions are squarish convex portions and surrounded by the recess portions, so that they do not overlap with each other. The roughened surface having such a complicated uneven shape can prevent the resin residue after the developing treatment while maintaining the adhesion properties to the solder resist forming resin and the metal beneath solder bump.

Furthermore, the ridgelines of the roughened surface are formed by dropping off adjoining metal crystal particles. These ridgelines connect the anchor portion and another adjacent anchor portion to each other at a position lower than the height of the anchor portion. These ridgelines can be formed at a branched state by dropping off three or more adjoining metal crystal particles. And also, the ridgelines can be formed at a sharp-edged state because the metal crystal particles are dropped off in approximately polyhedral shape. These ridgelines disperse the anchor portions so as to surround the anchor portion by the recess portions and the ridgelines. In the roughened surface having such amore complicated uneven shape, the contact area to the resin or the metal beneath solder bump is widened to more improve the adhesion property and the resin residue can be more prevented.

The roughened surface is preferable to have a maximum roughness (Rmax) of 0.5~10 µm. When it is less than 0.5 µm, the adhesion property to the solder resist layer and the adhesion property to the metal beneath solder bump are considerably lowered, while when it exceeds 10 µm, the resin residue is created after the developing treatment and it is apt to cause problems such as wiring breakage and the like.

And also, the roughened surface is favorable to have 2~100 anchor portions and 2~100 recess portions per 25 µm² on average. When the number of anchor portions per 25 µm² is 2~100 on average, the resin residue after the developing treatment can be prevented while maintaining the adhesion property between the roughened surface and the solder resist layer and the adhesion property between the roughened surface and the metal beneath solder bump, while when the number of recess portions per 25 µm² is 2~100 on average, the crowd of the anchor portions is prevented to control the occurrence of resin residue after the developing treatment and also the adhesion property between the roughened surface and the solder resist layer and the adhesion property between the roughened surface and the metal beneath solder bump can be maintained.

In the invention, the number of ridgelines per 25 µm² is desirable to be 3∼3000 on average. When the number of ridgelines is within the above range, the shape of the roughened surface becomes complicated and the contact area to the solder resist layer and the metal beneath solder bump is widened, whereby the adhesion property to the solder resist layer and the like can be improved and at the same time the resin residue can easily be removed.

Moreover, the number of each of anchor portions, recess portions and ridgelines is represented by an average of measured values when the roughened surface is pictured just above and obliquely from above by 45° by means of an electron microscope at 5000 magnification as shown in Figs. 2 and 3 and each number is measured at an optional region of 25 µm².

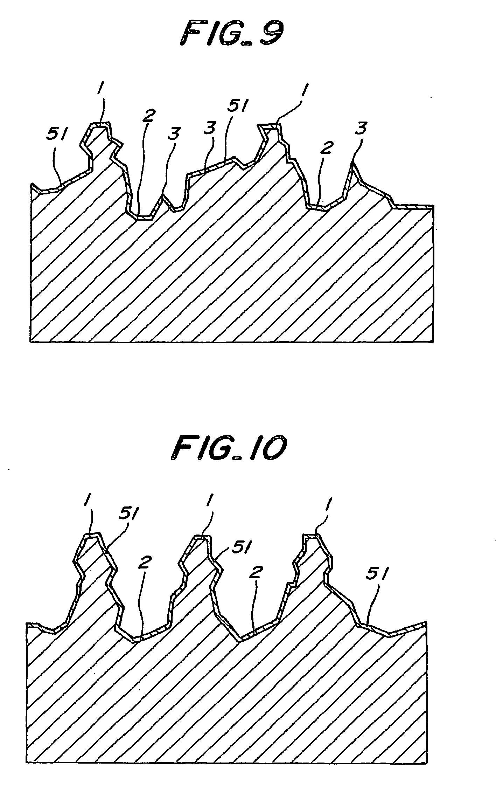

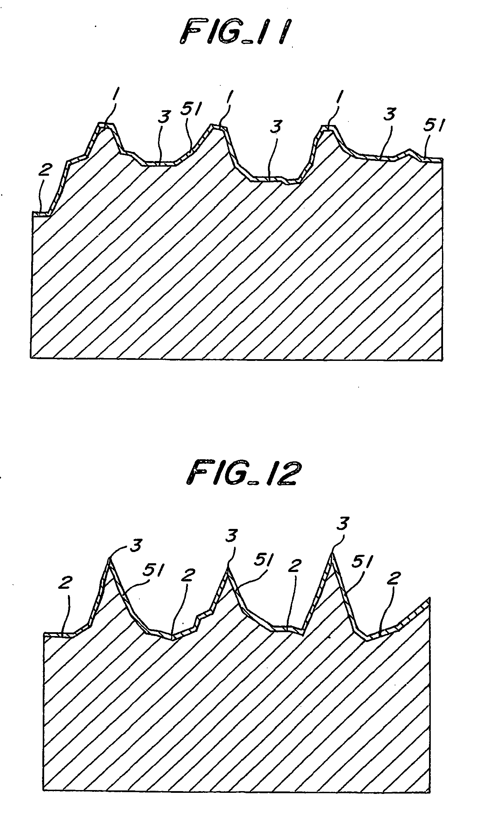

In the invention, the roughened surface is covered with the metal layer. Figs. 9~12 are section views of another embodiment of the roughened surface according to the invention. In Figs. 9~12, the roughened surface as shown in Figs. 4∼8 is covered with a metal layer 51.

The metal layer 51 as shown in Figs. 9~12 is made of a hardly oxidized or corroded metal or a metal not damaging the adhesion property to the solder resist forming resin or adhesion property to the metal beneath solder bump even if this metal itself is oxidized or corroded.

And also, the metal layer prevents the formation of oxide film or corrosion film on the roughened surface, and covers the roughened surface at a state of maintaining the shape of the roughened surface, and does not damage the adhesion property between the roughened surface and the solder resist forming resin or the metal beneath solder bump.

Such a metal layer can prevent the lowering of adhesion strength between the roughened surface and the solder resist layer or the adhesion strength between the roughened surface and the metal beneath solder bump.

Since the metal layer can increase the hardness of the metal constituting the roughened surface, metal breakage is not caused at the roughened surface, so that the peeling between the roughened surface and the solder resist layer or between the roughened surface and the metal beneath solder bump is more prevented.

In the printed wiring board according to the invention, the roughened surface has the metal layer, so that the oxidized or corroded layer is hardly formed on the roughened surface. If the oxidized or corroded layer is formed, the adhesion property to the solder resist forming resin or the metal beneath solder bump is maintained and hence the peeling between the roughened surface and the solder resist forming resin or between the roughened surface and the metal beneath solder bump is not caused even by heating.

The metal layer is made of at least one metal selected from the group consisting of titanium, zinc, iron, indium, thallium, cobalt, nickel, tin, lead, bismuth and a noble metal.

These metals hardly cause oxidation or corrosion, and if they are oxidized or corroded, the adhesion property to the solder resist forming resin or the metal beneath solder bump is not lowered.

And also, they are a metal or a noble metal having an ionization tendency larger than copper but not smaller than titanium. When the roughened surface is covered with a layer of such a metal or noble metal, there can be prevented the dissolution of the conductor circuit through local electrode reaction in the roughening of the solder resist layer.

As the hardly oxidizing or corroding metal, mention may be made of non-oxidizing metals such as nickel, tin, cobalt and noble metal. As the noble metal, at least one of gold, silver, platinum and palladium is desirable.

As the metal not lowering the adhesion property between the metal layer and the solder resist forming resin even if such a metal is oxidized or corroded, mention may be made of titanium, zinc, iron, indium, thallium, lead and bismuth.

Thus, when the roughened surface according to the invention is covered with the metal layer made of at least one metal selected from the group consisting of titanium, zinc, iron, indium, thallium, cobalt, nickel, tin, lead, bismuth and noble metal, the roughened shape suitable for preventing the resin residue after the developing treatment is maintained and the adhesion property between the conductor circuit for solder pad and the solder resist layer, adhesion property between the conductor circuit for solder pad and the metal beneath solder bump and the strength of the solder bump can be improved.

As a method of covering the roughened surface with the metal layer, use may be made of plating (electrolytic plating, electroless plating, substitution plating), vapor deposition, electrophoretic deposition, sputtering and the like.

The thickness of the metal layer is within a range of 0.01~1 µm, preferably 0.03~0.5 µm. The metal layer having the thickness within the above range can prevent oxidation or corrosion of copper conductor while maintaining the uneven shape of the roughened surface. When the thickness is less than 0.01 µm, the roughened surface can not completely be covered, while when it exceeds 1 µm, the metal penetrates into gaps of the roughened surface to offset the irregularity of the roughened surface and the adhesion property between the roughened surface and the solder resist layer or between the roughened surface and the metal beneath solder bump may be lowered.

The roughened surface according to the invention can be formed by treating the conductor circuits for solder pads with an etching solution containing copper(II) complex and an organic acid. Such an etching solution can dissolve the copper conductor circuits under an oxygen existing condition such as spraying, bubbling or the like. In this case, the etching is guessed to proceed according to the following reaction formula:

Cu + Cu(II)Aₙ → 2Cu(I)A_{n/2} → aeration → 2Cu(I)A_{n/2} + n/4O₂ + nAH → 2Cu(II)Aₙ + n/2H₂O

wherein A is a complexing agent (acting as a chelate agent) and n is coordination number).

As shown in the above reaction formula, the resulting copper(I) complex is dissolved by an acid and bonds with oxygen to form copper(II) complex, which again contributes to the oxidation of copper.

The copper(II) complex used in the invention is favorably a cupric complex of an azole. This type of the copper(II) complex acts as an oxidizing agent oxidizing metallic copper or the like. As the azole, there are mentioned diazoles, triazoles and tetrazoles. Among them, imidazole, 2-methylimidazole, 2-ethylimidazole, 2-ethyl-4-methylimidazole, 2-phenylimidazole, 2-undecylimidazole and the like are preferable. The addition amount of the copper(II) complex of the azole is preferably 1~15% by weight. Because, the complex is excellent in the solubility and stability within the above range.

The organic acid is compounded with the copper(II) complex for dissolving copper oxide. In case of using the copper(II) complex of the azole, the organic acid is favorably at least one selected from the group consisting of formic acid, acetic acid, propionic acid, butyric acid, valeric acid, caproic acid, acrylic acid, crotonic acid, oxalic acid, malonic acid, succeinic acid, gultaric acid, maleic acid, benzoic acid, glycolic acid, lactic acid, malic acid and sulfamic acid. The addition amount of the organic acid is preferably within a range of 0.1~30% by weight for maintaining the solubility of the oxidized copper and ensuring the solution stability.

To the etching solution according to the invention may be added a halogen ion such as fluorine ion, chlorine ion, bromine ion or the like for assisting the dissolution of copper and the oxidation action of the azole. Such a halogen ion may be supplied as hydrochloric acid, sodium chloride or the like. The addition amount of the halogen ion is favorably within a range of 0.01~20% by weight because the adhesion property between the resulting roughened surface and the solder resist layer is excellent.

The etching solution according to the invention can be prepared by dissolving the copper(II) complex of the azole and the organic acid (if necessary, halogen ion) in water. Alternatively, there may be used a commercially available etching solution, for example "Mech Etchbond", trade name, made by Mech Corporation.

An average etching quantity with the etching solution is favorably within a range of 0.1~10 µm. When it is less than 0.1 µm, the adhesion property between the roughened surface and the solder resist layer lowers, while when it exceeds 10 µm, the resin residue is apt to be caused and also the wiring breakage and the like are easily caused in the fine wiring of not more than 50 µm.

In the invention, the metal layer may be applied to the thus formed roughened surface. In this case, the metal layer is made of at least one metal selected from the group consisting of titanium, zinc, iron, indium, thallium, cobalt, nickel, tin, lead, bismuth and noble metal as mentioned above. The formation of the metal layer may be carried out by plating, vapor deposition, electrophoretic deposition or sputtering. The plating is preferable in view of the uniformity of the resulting metal layer.

In order to uniformly form the metal layer, according to the invention, the roughened layer after the roughening treatment may be subjected to a heat treatment prior to the formation of the metal layer. Since the etching solution and remaining components are evaporated by the heat treatment, the surface state of the roughened layer becomes uniform, which facilitates the formation of the metal layer.

The temperature of the heat treatment may be set to various ranges in accordance with the shape and thickness of the roughened surface, metallic components and thickness of the conductor circuit for solder pad and the like. Particularly, the temperature is favorably within a range of 50~250°C. When the temperature is lower than 50°C, the effect of the heat treatment is not observed, while when it exceeds 250°C, the roughened surface is oxidized and the resulting metal layer becomes ununiform.

The printed wiring board provided with a rust proof layer according to the invention is described with reference to the drawing.

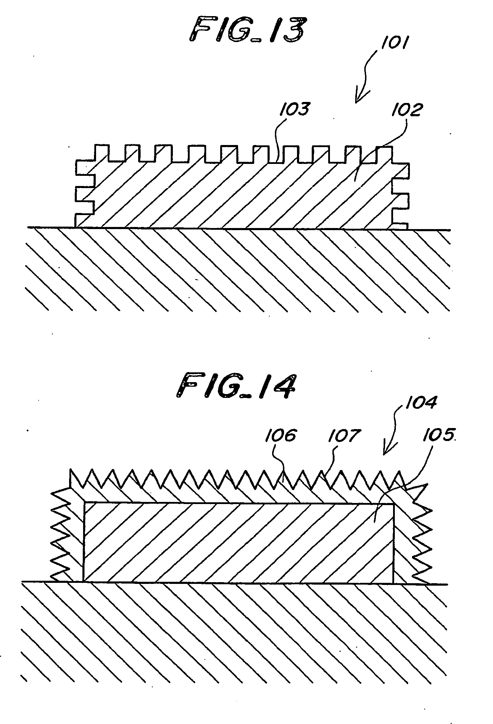

Fig. 13 shows a longitudinal section of an embodiment of the conductor circuit for solder pad to be provided with the rust proof layer according to the invention. Fig. 14 shows a longitudinal section of another embodiment of the conductor circuit for solder pad to be provided with the rust proof layer according to the invention.

The conductor circuit for solder pad provided with the rust proof layer according to the invention is disposed on an outermost layer of the printed wiring board and connected to an IC chip or the like through the solder bumps. Such a conductor circuit for solder pad is protected with the solder resist layer so as not to directly receive high temperature and high pressure from exterior and provided at its surface with the roughened surface for obtaining a high adhesion property to the solder resist layer and a high adhesion property to the solder pad.

The roughened surface for the formation of the rust proof layer according to the invention includes a roughened surface 103 formed by roughening a surface of a main body 102 of a conductor circuit 101 for solder pad through graphitization-reduction treatment, etching or the like as shown in Fig. 13, and a roughened surface 107 formed by precipitating a roughened layer 106 made of an electroless plated film or the like on a surface of a main body 105 of a conductor circuit 104 for solder pad as shown in Fig. 14.

In the printed wiring board provided with the rust proof layer according to the invention, the roughened surface is formed on the conductor circuit for solder pad as a surface layer of the printed wiring board provided with conductor circuits through various steps. The formation of the roughened surface for the formation of the rust proof layer is carried out by anyone of oxidation-reduction treatment, electroless plating and etching treatment. Particularly, the formation of the roughened layer made of copper-nickel-phosphorus alloy and the roughened surface formed with an etching solution containing a copper(II) complex and an organic acid are preferable in view of the adhesion property to the solder resist layer and uniformity of the roughened surface.

When the roughened surface is formed by oxidation-reduction treatment, it may be formed by washing the printed wiring board having the conductor circuits with an alkali or the like, treating with an acid, immersing in a solution containing NaOH, NaClO₂, Na₂PO₄ and the like as an oxidation bath (graphitization bath) and then immersing in a solution containing NaOH and NaBH₄ as a reduction bath. A maximum height of the roughened surface is within a range of 0.01~2 µm.

The oxidation bath (graphitization bath) is desirably used to have a concentration range of NaOH: 1~30 g/L, NaClO₂: 5~6 g/L and Na₃PO₄: 0.1~20 g/L and may contain nitrogen-based or urea-based surfactant and the like. It is preferable that the conductor circuit is immersed in this plating solution at a temperature of 30~70°C for 1~15 minutes. The subsequent reduction bath is desirably used to have a composition range of NaOH: 1~30 g/L and NaBH₄: 0.5~20 g/L and may contain various additives. It is preferable that the conductor circuit is immersed in this plating solution at a temperature of 30∼70°C for 1∼15 minutes. Thus, the roughened surface may be formed on the surface layer of the conductor circuit.

When the roughened surface is formed by electroless plating, it may be formed by immersing the printed wiring board having the conductor circuits in an electroless plating solution after the washing with an alkali or the like, the etching, the treatment with an acid and the application and activation of a catalyst. A maximum height of the roughened surface is within a range of 0.1~10 µm.

As an example of forming the roughened surface by electroless plating, there is a method of forming the roughened layer made of copper-nickel-phosphorus alloy. In this case, the plating solution is desirably used to have a concentration range of copper (metal salt such as copper sulfate, copper chloride or the like): 1~40 g/L, nickel (metal salt such as nickel sulfate or the like): 0.1~6 g/L, citric acid: 10~20 g/L, hypophosphite: 10~100 g/L, boric acid: 10∼40 g/L and surfactant: 0.01~10 g/L and may contain various additives, stabilizer and the like. It is favorable that the conductor circuit is immersed in this plating solution at a temperature of 50~80°C for 5∼20 minutes. Thus, the roughened surface consisting of the plated layer and the roughened layer may be formed on the surface layer of the conductor circuit.

As the shape of the roughened surface, there are needle shape, porous shape and a combination thereof. The needle shape is favorable from a viewpoint of forming easiness and adhesion property. A maximum height of the roughened surface is within a range of 0.5~10 µm, preferably 1~5 µm. When it is less than 0.5 µm, the adhesion property to the solder resist layer lowers, while when it exceeds 10 µm, the peeling of the solder resist layer and the cracking are caused because the uniformity of the roughened surface is not held in the oxidation-reduction treatment and the electroless plating.

As an example of forming the roughened surface with the etching solution, there may be mentioned a method of treating with the aforementioned etching solution containing copper(II) complex and organic acid. In this case, the etching solution can dissolve copper conductor circuit under an oxygen existing condition such as spraying, bubbling or the like.

In the invention, the rust proof layer may be formed on the above conductor circuit for solder pad. The rust proof layer according to the invention is desirable to contain at least one anti-rust agent selected from the group consisting of 1,2,3-benzotriazole, tollyltriazole and derivatives thereof as a main component.

Here, 1,2,3-benzotriazole and triazole derivatives mean compounds wherein an alkyl group such as methyl group, ethyl group or the like, or carboxyl group, amino group, hydroxyl group or the like is bonded to a benzene ring as shown by the following chemical formulae (1), (2):

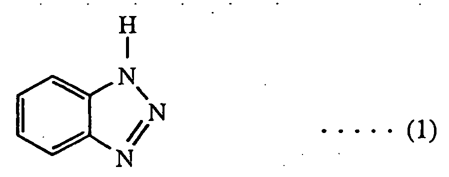

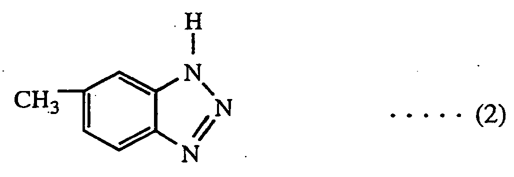

These compounds are excellent in the rust proofing effect of copper because they control the oxidation reaction of copper. And also, they do not remain on a pad of a conductor circuit exposed in an opening for a solder pad because they easily dissolve in a solvent used for the light exposure and development of the solder resist layer. As a result, even if the opening portion is formed in the pad of the conductor circuit for solder pad, the continuity between the conductor circuit and the solder bump is ensured without being insulated.

On the other hand, the rust proof layer remains on the boundary face between the conductor circuit for solder pad and the solder resist layer. As a result, the film of the remaining rust proof layer can prevent the deformation and deterioration of the conductor circuit for solder pad by oxidation and corrosion caused through water, air and the like penetrated from the solder resist layer and solder pad portion under conditions of high temperature, high pressure and high humidity.

The formation of the rust proof layer can be carried out by coating, spraying or immersion. Particularly, the immersion method is favorable because the rust proof layer can evenly be formed on the conductor circuit without damaging the roughened surface. As an example of the immersion method, the rust proof layer can be formed on the roughened surface of the conductor circuit in the printed wiring board by immersing the printed wiring board in a tank having a depth corresponding to approximately a whole of the conductor circuit at a temperature of 20~60°C for an immersion time of 10~600 seconds.

In the invention, after the solder resist layer is formed on the rust proof layer and is subjected to a light exposure and development to form an opening portion, the rust proof layer exposed in the opening portion is can be removed by a gas plasma.

As such a treating method, there may be mentioned a method wherein the printed wiring board provided with the opening portion for solder pad formed through light exposure and development is placed in a device held at a vacuum state and a plasma of oxygen, nitrogen, carbon dioxide gas or carbon tetrafluoride is discharged therein to remove the anti-rust agent remaining in the opening portion, residue of the solder resist layer and an oxide film layer on the surface of the solder resist layer.

In case of the plasma treatment, optimum conditions for eliminating the contamination of the solder bump and reducing the poor mounting are that plasma discharging quantity is 500~1000 W, and a gas feeding amount is 100~500 sec/M and a treating time is 1~15 minutes.

The anti-rust agent existing in the opening portion and the residue of the solder resist layer are surely removed by the plasma treatment, whereby poor conduction to the solder bump is eliminated. At the same time, the oxide film layer on the surface of the solder resist layer is removed, so that there can be prevented the occurrence of inconvenience at subsequent plating step and mounting step without lowering the wettability of the solder resist layer.

Moreover, according to the invention, after the roughened surface is formed on the conductor circuit, a metal layer for rust proof layer made of at least one metal selected from the group consisting of titanium, zinc, iron, indium, thallium, cobalt, nickel, tin, lead, bismuth and noble metal may be formed on the roughened surface prior to the application of the anti-rust agent.

The formation of such a metal layer for the rust proof layer can be carried out by plating (anyone of electrolytic plating, electroless plating and substitution plating), vapor deposition, electrophoretic deposition or sputtering. When the metal layer for the rust proof layer is formed by the substitution plating, this metal layer is formed on a surface layer portion of the roughened surface of the conductor circuit for solder pad.

The thickness of the metal layer formed as an undercoat for the rust proof layer according to the invention is preferably within a range of 0.01~1 µm, more particularly 0.03∼0.5 µm. When the thickness is less than 0.01 µm, the roughened surface can not completely be covered, while when it exceeds 1 µm, the covering metal penetrates into the roughened surface to offset the roughened shape to thereby lower the adhesion property.

The above rust proof layer is formed on the roughened surface covered with the metal layer for the rust proof layer. As a result, the deformation and deterioration of the roughened surface through oxidation and the like are prevented by the synergistic action of the metal layer and the rust proof layer, so that the adhesion property and strength to the solder resist layer become uniform and the peel strength of the solder bump is improved. Therefore, the shape of the roughened surface hardly deteriorates even under conditions of high temperature, high pressure and high humidity in the reliability test and the strengths of the solder resist layer and the solder bump are improved.

According to the invention, in order to improve the penetrability of the anti-rust agent into the roughened surface and to uniformize the thickness and composition of the metal layer for rust proof layer covering the roughened surface, the conductor circuit for solder pad after the formation of the roughened surface may be subjected to a heat treatment within a range of 50~250°C prior to the formation of the metal layer and the rust proof layer.

The heat treating conditions can be set to adequate ranges in accordance with the shape, thickness and material of the resulting roughened surface, component and thickness of the metal layer for rust proof layer covering the roughened surface and the like.

By such a heat treatment are evaporated extra component of a chemical used for the formation of the roughened surface and residual component thereof, and the surface layer of the roughened surface and the metal state of the conductor circuit as a whole become uniform, which facilitate the formation of the metal layer and the rust proof layer.

When the heating temperature is lower than 50°C, the effect of the heat treatment is not observed, while when it exceeds 250°C, the roughened surface is oxidized and the resulting metal layer and the rust proof layer become ununiform.

In the invention, the solder resist layer is formed on the thus formed roughened surface having a given shape. The thickness of the solder resist layer is preferably 2∼40 µm. When the thickness is too thin, the solder resist layer does not act as a solder dam, while when the thickness is too thick, it is difficult to form the opening portion for solder bump and also the contacting with the solder body may be caused to bring about the occurrence of cracking in the solder body.

The solder resist layer can be made from various resins. For example, it can be formed by curing bisphenol A-type epoxy resin or an acrylate thereof, or novolac type epoxy resin or an acrylate thereof with an amine curing agent, an imidazole curing agent or the like.

Particularly, when the solder resist layer is opened to dispose the solder bump thereon, it is favorable to cure the novolac type epoxy resin or an acrylate thereof with an imidazole curing agent. The solder resist layer made of such a resin has a merit that migration of lead (phenomenon of diffusing lead ion into the solder resist layer) is less.

And also, when the acrylate of the novolac type epoxy resin is cured with the imidazole curing agent, the resulting solder resist layer is excellent in the heat resistance and resistance to alkali and is not deteriorated even at a temperature of fusing the solder (about 200°C) and is not decomposed with a strong base plating solution such as nickel plating solution or gold plating solution. As the acrylate of the novolac type epoxy resin, mention may be made of epoxy resin formed by reacting glycidyl ether of phenol novolac or cresol novolac with acrylic acid or methacrylic acid, and the like.

However, the solder resist layer made from the acrylate of novolac type epoxy resin is constituted with a resin having a rigid skeleton, so that it is apt to cause the peeling from the conductor circuit. In this connection, the roughened surface according to the invention can advantageously prevent the above peeling.

The imidazole curing agent is desirable to be liquid at 25°C because the uniform mixing is easily attained. As such a curing agent, mention may be made of 1-benzyl-2-methyl imidazole (trade name: 1B2ZM), 1-cyanoethyl-2-ethyl-4-methyl imidazole (trade name: 2E4MZ-CN) and 4-methyl-2-ethyl imidazole (trade name: 2E4MZ).

It is desirable to form a solder resist composition by dissolving the above resin and curing agent in a solvent such as glycol ether or the like. When the solder resist layer is formed from such a composition, free oxygen is not created and hence the surface of copper pad is not oxidized, and also the injury to human body is less.

As the glycol ether solvent, use may be made of a solvent represent by the following chemical formula (3):

CH₃O - (CH₂ CH₂ O)n - CH₃ (n = 1~5) (3)

Preferably, there is used at least one of diethylene glycol dimethyl ether (DMDG) and triethylene glycol dimethyl ether (DMTG). Such a solvent can completely dissolve a reaction initiator such as benzophenone, Michler ketone or the like by warming to about 30~50°C. The amount of the solvent is preferably within a range of 10~40% by weight to the solder resist composition.

The addition amount of the imidazole curing agent is desirable to be 1~10% by weight based on a total solid content of the solder resist composition. When the addition amount is within the above range, the uniform mixing is easily attained.

The solder resist composition may be added with an anti-foaming agent, a leveling agent, an initiator, a photosensitizer, a thermosetting resin for improving heat resistance and resistance to base and giving a flexibility, a photosensitive monomer for improving a resolution, and the like.

As the leveling agent, a polymer of acrylic ester is favorable. As the initiator, Irgaquar 1907 (trade name, made by Ciba Geigy) is favorable. As the photosensitizer, DETX-S (trade name, made by Nippon Kayaku Co., Ltd.) is favorable.

As the thermosetting resin, bisphenol type epoxy resin can be used. As the bisphenol type epoxy resin, there are bisphenol A-type epoxy resin and bisphenol F-type epoxy resin. The former is used in case of improving the resistance to base, and the latter is used in case of decreasing the viscosity (i.e. improvement of applicability).

As the photosensitive monomer, a polyvalent acrylic monomer can be used because it can improve the resolution. For example, there can be used polyvalent acrylic monomers such as DPE-6A (trade name, made by Nippon Kayaku Co., Ltd.), R-604 (trade name, made by Kyoeisha Kagaku Co., Ltd) and the like.

And also, the solder resist composition may contain a coloring matter, a pigment and the like for shielding the wiring pattern. As the coloring matter, it is desirable to use phthalocyanine blue.

The solder resist composition is favorable to have a viscosity of 0.5~10 Pa·s, preferably 1~10 Pa·s at 25°C for facilitating the application through a roll coater.

In the solder resist layer made of the solder resist composition, an opening portion can be formed by light exposure and developing treatment.

The production method of the printed wiring board according to the invention will be described below. This method is mainly carried out by a semi-additive process, but a full-additive process can be adopted.

In the invention, a wiring board is first prepared by forming conductor circuit as a solder pad on a surface of a substrate. As the substrate, use may be made of a resin insulating substrate such as a glass epoxy resin substrate, a polyimide substrate, a bismaleimide triazine substrate or the like, a ceramic substrate, a metal substrate and so on.

Such a wiring board may be a multilayer printed wiring board provided in its interior with plural layers of conductor circuit. As a method of forming such plural conductor circuit layers, for example, there is a method of forming an adhesive layer made of an adhesive for electroless plating as an interlaminar insulating resin layer on an underlayer conductor circuit formed on the substrate, roughening the surface thereof, subjecting the whole of the roughened surface to an electroless thin plating, forming a plating resist thereon, subjecting portions not forming the plating resist to an electrolytic thick plating, removing the plating resist and etching to form a conductor circuit of two layers consisting of the electroless plated film and the electrolytic plated film. In any case, the conductor circuit is preferable to be a copper pattern.

The adhesive for electroless plating is optimum to be formed by dispersing cured heat-resistant resin particles soluble in an acid or an oxidizing agent into an uncured heat-resistant resin hardly soluble in the acid or oxidizing agent. These heat-resistant resin particles are removed by treating with the acid or oxidizing agent, whereby a roughened surface having octopus pot-shaped anchors is formed. Moreover, the adhesive for electroless plating may be constituted with two layers having different compositions.

As the cured heat-resistant resin particles soluble in the acid or oxidizing agent, it is desirable to use at least one selected from the group consisting of (1) heat-resistant resin particles having an average particle size of not more than 10 µm, (2) aggregate particles of heat-resistant resin powder having an average particle size of not more than 2 µm, (3) a mixture of heat-resistant resin powder having an average particle size of 2~10 µm and heat-resistant resin powder having an average particle size of less than 2 µm, (4) false particles obtained by adhering at least one of heat-resistant resin powder and inorganic powder having an average particle size of not more than 2 µm to the surface of heat-resistant resin powder having an average particle size of 2~10 µm, (5) a mixture of heat-resistant resin powder having an average particle size of 0.1~0.8 µm and heat-resistant resin powder having an average particle size of more than 0.8 µm but less than 2 µm, and (6) heat-resistant resin powder having an average particle size of 0.1~1.0 µm. These particles form more complicated anchors. The roughened surface made from these particles is possible to have a maximum roughness (Rmax) of 0.1~20 µm.

The amount of the heat-resistant resin particles used is 5~50% by weight, preferably 10~40% by weight based on solid content of a matrix made of the heat-resistant resin. As the resin forming the heat-resistant resin particles, it is preferable to use amino resin (melamine resin, urea resin, guanamine resin and the like), epoxy resin and so on.

As the uncured heat-resistant resin hardly soluble in the acid or oxidizing agent, it is desirable to use a resin composite of thermosetting resin and thermoplastic resin, or a resin composite of photosensitive resin and thermoplastic resin. The former is high in the heat resistance, while the latter can form an opening for via-hole through photolithography.

As the thermosetting resin, use may be made of epoxy resin, phenolic resin, polyimide resin and the like. In case of photosensitizing this resin, thermosetting group is acrylated with acrylic acid or methacrylic acid. Particularly, an acrylate of epoxy resin is most suitable. As the epoxy resin, use may be made of novolac type epoxy resin such as phenol novolac type epoxy resin, cresol novolac type epoxy resin or the like, and an alicyclic epoxy resin modified with dicyclopentadiene and so on.

As the thermoplastic resin, use may be made of polyether sulphone (PES), polysulphone (PSF), polyphenylene sulphone (PPS), polyphenylene sulfide (PPES), polyphenyl ether (PPE), polyether imide (PI) and so on.

The mixing ratio of thermosetting resin (photosensitive resin) to thermoplastic resin is preferably 95:5 ~ 50:50. Within the above range, higher properties are obtained without damaging the heat resistance.

The adhesive for electroless plating is cured to from an interlaminar insulating resin layer, while an opening for the formation of via-hole is formed on the interlaminar insulating resin layer.

The opening for the formation of via-hole is formed by using a laser beam, an oxygen plasma or the like when the resin matrix of the adhesive for electroless plating is a thermosetting resin, or by light exposure and developing treatment when the resin matrix is a photosensitive resin. Moreover, the light exposure and developing treatment are carried out after a photomask depicted with circle patter for the formation of via-hole (glass substrate is favorable) is placed on the photosensitive interlaminar insulating resin layer so as to close the side of the circle pattern to the layer.

Then, the surface of the interlaminar insulating resin layer provided with the opening for the formation of via-hole (adhesive layer electroless plating) is roughened. Particularly, the surface of the adhesive layer is roughened by dissolving and removing the heat-resistant resin particles existing on the surface of the adhesive layer for electroless plating with an acid or oxidizing agent. Thus, the roughened surface is formed on the interlaminar insulating resin layer.

As the acid, use may be made of inorganic acids such as phosphoric acid, hydrochloric acid, sulfuric acid and the like, or organic acids such as formic acid, acetic acid and the like. Particularly, the use of the organic acid is desirable because it hardly corrodes the metal conductor layer exposed from the via-hole. As the oxidizing agent, it is desirable to use chromic acid, chromium sulfate and permanganate (potassium permanganate and the like).

The roughened surface is favorable to have a maximum roughness (Rmax) of 0.1=20 µm. When the roughness exceeds the upper limit, the interlaminar insulating resin layer itself is apt to be damaged or peeled off, while when it is less than lower limit, the adhesion property lowers. Particularly, the roughness is favorably 0.1~5 µm in the semi-additive process because the electroless plated film is removed while ensuring the adhesion property.

After a catalyst nucleus is applied to the roughened interlaminar insulating resin layer, an electroless plated thin film is formed over a full surface of the layer. The electroless plated film is preferably an electroless copper plated film and has a thickness of 1~5 µm, desirably 2~3 µm. As the electroless copper plating solution can be used a composition usually used in this field. For example, there is a plating solution having a composition of copper sulfate: 10 g/L, EDTA: 50 g/L, sodium hydroxide: 10 g/L and 37% formaldehyde: 10 mL (pH = 11.5).

Then, a photosensitive resin film (dry film) is laminated onto the thus formed electroless plated film and a photomask depicted with a plating resist pattern (glass substrate is favorable) is placed on the photosensitive resin film, which is subjected to a light exposure and a developing treatment to from non-conductor portions corresponding to the plating resist pattern.

Thereafter, an electrolytic plated film is formed on the electroless plated film other than the non-conductor portions to from conductor circuits and conductor portions corresponding to via-holes. As the electrolytic plating it is desirable to use an electrolytic copper plating, and the thickness of the electrolytic plated film is favorably 5~20 µm.

After the plating resist corresponding to the non-conductor portions is removed, the electroless plated film is further removed with a mixed solution of sulfuric acid and hydrogen peroxide or an etching solution of sodium persulfate, ammonium persulfate, iron chloride, copper chloride or the like, whereby there are obtained independent conductor circuits and via-hole each comprising two layers of the electroless plated film and the electrolytic plated film. Moreover, the catalyst nucleus existing on the roughened surface exposed from the non-conductor portions is dissolved and removed with a mixed solution of chromic acid, sulfuric acid and hydrogen peroxide or the like.

Then, roughened surface according to the invention is formed on the conductor circuits for solder pad as a surface layer. Such a roughened surface can be formed by spraying an etching solution comprising copper(II) complex of azole and an organic acid as previously mentioned to the surface of the conductor circuit, or by immersing the conductor circuit in such an etching solution and then bubbling it. Moreover, the conductor circuit is desirable to be the electroless plated film or the electrolytic plated film because it is difficult to form a roughened surface in a conductor circuit formed by etching a rolled copper foil.

The thus formed roughened surface may be subjected to an etching treatment, polishing treatment, oxidation treatment, oxidation-reduction treatment and the like, or may be covered with a plated film at subsequent steps.

And also, the roughened surface may be covered with a metal layer made of at least one metal selected from the group consisting of titanium, zinc, iron, indium, thallium, cobalt, nickel, tin, lead, bismuth and noble metal. Such a covering may be carried out by plating (either one of electrolytic plating, electroless plating and substitution plating), vapor deposition, electrophoretic deposition, sputtering or the like.

The roughened surface to be provided with the rust proof layer according to the invention is favorable to be formed at a maximum height of 0.5~10 µm, preferably 1~5 µm through oxidation-reduction treatment, electroless plating or etching treatment.

As an example for the formation of the roughened surface with the electroless plating solution, there is a method of immersing in a plating solution of copper-nickel-phosphorus.

As an example for the formation of the roughened surface by the etching, there is a method of spraying an aqueous solution of copper(II) complex of azole and organic acid as an etching solution to the surface of the conductor circuit or a method of immersing the conductor circuit in the above etching solution and bubbling it.

Onto the thus formed roughened surface may be formed a metal layer for rust proof layer made of at least one metal selected from the group consisting of titanium, zinc, iron, indium, thallium, cobalt, nickel, tin, lead, bismuth and noble metal. This is carried out by plating (either one of electrolytic plating, electroless plating and substitution plating), vapor deposition, electrophoretic deposition or sputtering.

In the invention, a rust proof layer may be formed on the above roughened surface or the metal layer for rust proof layer. The formation of the rust proof layer is carried out by applying an anti-rust agent, or by spraying the anti-rust agent, or by immersing the conductor circuit for solder pad in the anti-rust agent. Particularly, the immersion method is favorable because it can evenly form the rust proof layer over the conductor circuit without damaging the roughened surface for the rust proof layer.

As an example of the immersion method, the rust proof layer can be formed on the roughened surface of the conductor circuit for solder pad or on the metal layer for rust proof layer formed on the roughened surface by immersing the roughened surface or the metal layer for rust proof layer in a tank with a depth fully immersing the conductor circuit of the printed wiring board at a temperature of 20~60°C for an immersing time of 10~600 seconds.

The aforementioned solder resist layer is formed on the conductor circuit having the above treated roughened surface.

The invention will be described with respect to the following examples and comparative examples with reference to the drawings.

### Example 1

### Starting composition for the preparation of an adhesive for electroless plating

### (Adhesive for upperlayer)

### [Resin composition A]

This is obtained by mixing 35 parts by weight of a resin solution formed by dissolving 25% acrylate of cresol novolac type epoxy resin (made by Nippon Kayaku Co., Ltd. molecular weight: 2500) in DMDG at a concentration of 80% by weight, 3.15 parts by weight of a photosensitive monomer (Aronix M315, trade name, made by Toa Gosei Co., Ltd.), 0.5 part by weight of an anti-foaming agent (S-65, trade name, made by Sannopuco Co., Ltd.) and 3.6 parts by weight of NMP with stirring.

### [Resin composition B]

This is obtained by mixing 12 parts by weight of polyether sulphone (PES), 7.2 parts by weight of epoxy resin particles having an average particle size of 1.0 µm (Polymerpole, trade name, made by Sanyo Kasei Co., Ltd.) and 3.09 parts by weight of the same resin particles having an average particle size of 0.5 µm, adding 30 parts by weight of NMP and mixing them in a beads mill with stirring.

### [Curing agent composition C]

This is obtained by mixing 2 parts by weight of an imidazole curing agent (2E4MZ-CN, trade name, made by Shikoku Kasei Co., Ltd.), 2 parts by weight of a photoinitiator (Irgaquar I-907, trade name, made by Ciba Geigy), 0.2 part by weight of a photosensitizer (DETX-S, trade name, made by Nippon Kayaku Co., Ltd.) and 1.5 parts by weight of NMP with stirring.

### Starting composition for the preparation of interlaminar resin insulating agent (Adhesive for underlayer)

### [Resin composition D]

This is obtained by mixing 35 parts by weight of a resin solution formed by dissolving 25% acrylate of cresol novolac type epoxy resin (made by Nippon Kayaku Co., Ltd. molecular weight: 2500) in DMDG at a concentration of 80% by weight, 4 parts by weight of a photosensitive monomer (Aronix M315, trade name, made by Toa Gosei Co., Ltd.), 0.5 part by weight of an anti-foaming agent (S-65, trade name, made by Sannopuco Co., Ltd.) and 3.6 parts by weight of NMP with stirring.

### [Resin composition E]

This is obtained by mixing 12 parts by weight of polyether sulphone (PES) and 14.49 parts by weight of epoxy resin particles having an average particle size of 0.5 µm (Polymerpole, trade name, made by Sanyo Kasei Co., Ltd.), adding 30 parts by weight of NMP and mixing them in a beads mill with stirring.

### [Curing agent composition F]

This is obtained by mixing 2 parts by weight of an imidazole curing agent (2E4MZ-CN, trade name, made by Shikoku Kasei Co., Ltd.), 2 parts by weight of a photoinitiator (Irgaquar I-907, trade name, made by Ciba Geigy), 0.2 part by weight of a photosensitizer (DETX-S, trade name, made by Nippon Kayaku Co., Ltd.) and 1.5 parts by weight of NMP with stirring.

### Starting composition for the preparation of resin filler

### [Resin composition G]

This is obtained by mixing 100 parts by weight of bisphenol F-type epoxy monomer (YL983U, trade name, made by Yuka Shell Co., Ltd. molecular weight of 310), 170 parts by weight of SiO₂ spherical particles coated with a silane coupling agent and having an average particle size of 1.6 µm (CRS 1101-CE, trade name, made by Adomatec Co., Ltd. A maximum particle size is not more than a thickness (15 µm) of an innerlayer copper patter as mentioned below) and 1.5 parts by weight a leveling agent (Perenol S4, trade name, made by Sannopuco Co., Ltd.) with stirring to adjust a viscosity of the resulting mixture to 45,000-49,000 cps at 23 ± 1°C.

### [Curing agent composition H]

6.5 parts by weight of an imidazole curing agent (2E4MZ-CN, trade name, made by Shikoku Kasei Co., Ltd.)

### Production of printed wiring board

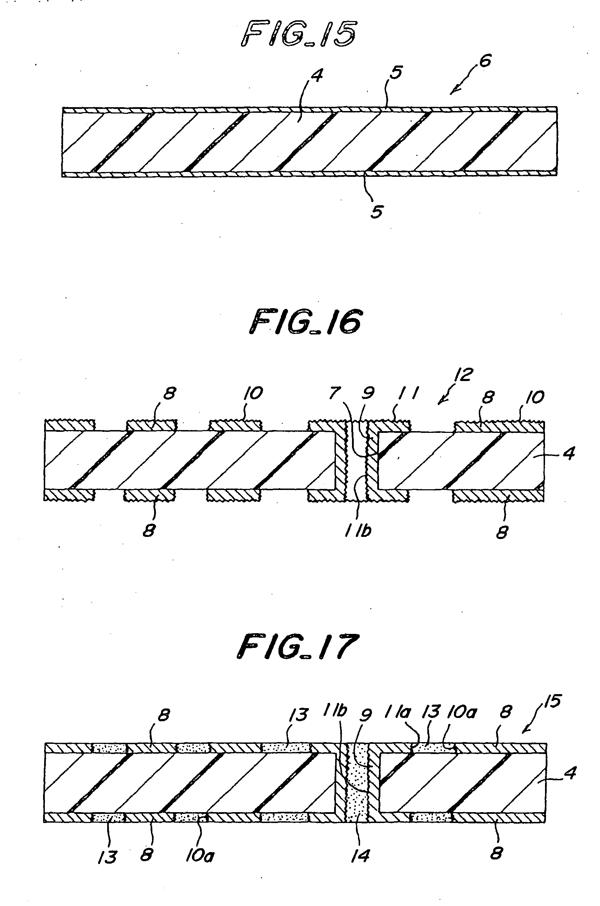

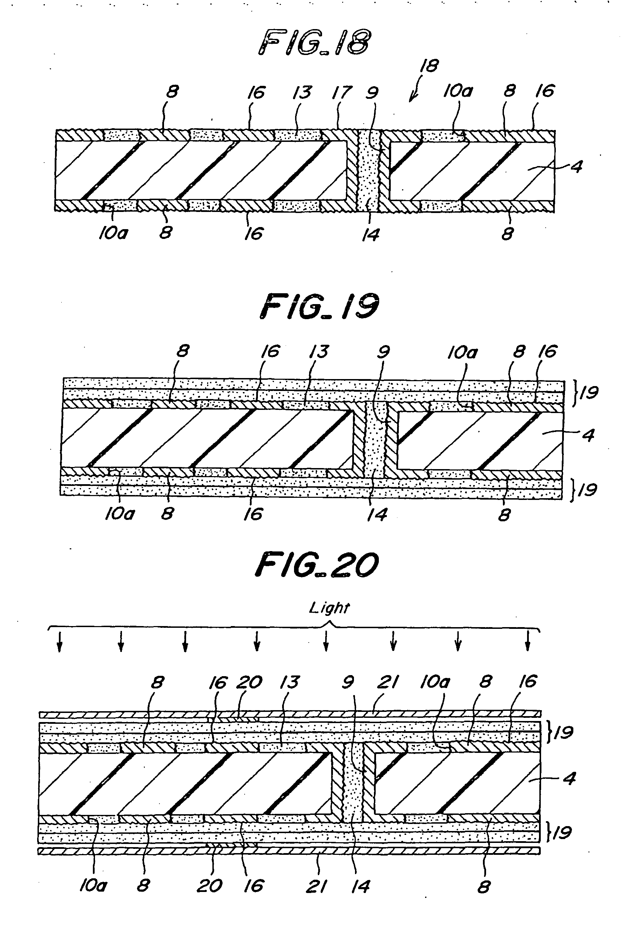

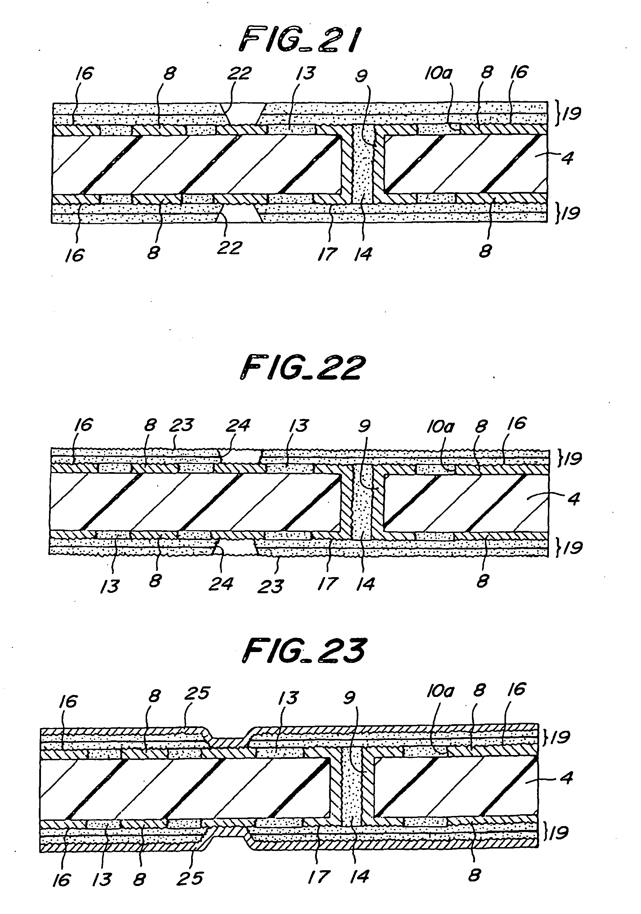

An embodiment of the printed wiring board according to the invention is produced according to a series of production steps shown in Figs. 15 to 32.
(1) As a starting material, there is provided a copper clad laminate 6 obtained by laminating a copper foil 5 of 18 µm in thickness onto each surface of a substrate 4 made of a glass epoxy resin or BT (bismaleimide triazine) resin having a thickness of 1 mm as shown in Fig. 15.
At first, the copper clad laminate 6 is subjected to an electroless plating after the formation of a drilled hole 7 as shown in Fig. 16, and etched in form of a pattern to form innerlayer copper pattern (underlayer conductor circuits) 8 and a through-hole 9 on both surfaces of the substrate 6.
(2) The substrate provided with the innerlayer copper pattern 8 and the through-hole 9 is washed with water, dried and subjected to an oxidation-reduction treatment using NaOH (10 g/L), NaClO₂ (40 g/L) and Na₃PO₄ (6 g/L) as an oxidation bath (graphitization bath) and NaOH (10 g/L) and NaBH₄ (6 g/L) as a reduction bath to form roughened surfaces 10, 11 on the innerlayer copper pattern 8 and the surface of the through-hole 9, whereby there is produced a wiring board 12 as shown in Fig. 16.
(3) A resin filler is prepared by mixing and kneading the resin composition G and the curing agent composition H. Within 24 hours after the preparation, the resin filler is applied onto both surfaces of the board 12 by means of a roll coater to fill in spaces between the conductor circuits 8 and the through-hole 9, which is dried by heating at 70°C for 20 minutes to form resin layers 13, 14.
(4) After the completion of the above treatment (3), a surface of the board is polished by a belt sander polishing with #600 belt polishing paper (made by Sankyo Rikagaku Co., Ltd.) so as not to leave the resin filler on the surface of the innerlayer copper pattern 8 and the surface of a land 11 of the through-hole 9 and buffed for removing flaws created by the belt sander polishing. The other surface of the board is carried out in the same treatment as mentioned above.
(5) Then, the resin filler is cured by heating at 100°C for 1 hour, 120°C for 3 hours, 150°C for 1 hour and 180°C for 7 hours to form a wiring board 15 as shown in Fig. 17. In the wiring board 15, the roughened surfaces 10, 11 on the surface layer portion of the resin filler filled in the through-hole 9 and the like and the upper surface of the innerlayer conductor circuit 8 are removed to smoothen the surface of the board, while the resin layer 13, the side face of the innerlayer conductor circuit 8 and the land surface of the through-hole 9 are strongly adhered to each other through the roughened surfaces 10a, 11 a and the inner wall face of the through-hole 9 and the resin layer 14 are strongly adhered to each other through the roughened surface 11a. That is, the surfaces of the resin layers 13, 14 and the surface of the innerlayer copper pattern 8 become the same plane at this step.
(6) The printed wiring board 15 provided with the conductor circuits is degreased with an alkali, soft etched, treated with a catalyst solution containing palladium chloride and an organic acid to form a Pd. catalyst. After the activation of this catalyst, it is immersed in an electroless plating solution of pH = 9 containing 3.2 x 10⁻² mol/L of copper sulfate, 3.9 x 10⁻³ mol/L of nickel sulfate, 5.4x 10⁻² mol/L of sodium citrate, 3.3 x 10⁻¹ mol/L of sodium hypophosphite and 1.1 x 10⁻⁴ mol/L of a surfactant (Surfeel 465, trade name, made by Nisshin Kagaku Kogyo Co., Ltd.). After 1 minute of the immersion, it is vibrated and rocked 1 times per 4 seconds to form roughened layers 16, 17 of Cu-Ni-P needle-shaped alloy on the surfaces of the copper conductor circuits 8 and the land of the through-hole 9 as shown in Fig. 18.
Furthermore, Cu-Sn substitution reaction is carried out under conditions of 0.1 mol/L of tin borofluoride, 1.0 mol/L of thiourea, temperature of 35°C and pH = 1.2 to form Sn layer of 0 3 µm in thickness on the surfaces of the roughened layers 16, 17. Moreover, the Sn layer is not shown.
(7) The above resin composition D, resin composition E and curing agent composition F are mixed with stirring so as to adjust the viscosity to 1.5 Pa·s, whereby an interlaminar resin insulating agent (for underlayer) is obtained. Then, the above resin composition A, resin composition B and curing agent composition C are mixed with stirring so as to adjust the viscosity to 7 Pa.s, whereby an adhesive solution for electroless plating (for upperlayer) is obtained.
(8) The interlaminar resin insulating agent (for underlayer) having the viscosity of 1.5 Pa·s of the above item (7) is applied onto both surfaces of the board 18 of the item (6) by means of a roll coater within 24 hours after the preparation, left to stand at a horizontal state for 20 minutes and dried (baked) at 60°C for 30 minutes. Then, the photosensitive adhesive solution (for upperlayer) having the viscosity of 7 Pa·s of the item (7) is applied within 24 hours after the preparation, left to stand at a horizontal state for 20 minutes and dried (baked) at 60°C for 30 minutes to form an adhesive layer 19 having a thickness of 35 µm as shown in Fig. 19.
(9) As shown in Fig. 20, a photomask film 21 depicted with black circles of 85 µmφ is adhered to each surface of the board provided with the adhesive layer 19 in the item (8) and exposed to a super-high pressure mercury lamp at 500 mJ/cm². The board is developed by spraying DMTG solution, exposed to a super-high pressure mercury lamp at 3000 mJ/cm², and subjected to a heating treatment (post baking) at 100°C for 1 hour, 120°C for 1 hour and 150°C for 3 hours, whereby an interlaminar resin insulating layer (two-layer structure) 19 of 35 µm in thickness having an opening (opening for the formation of via-hole) 22 of 85 µmϕ with an excellent size accuracy corresponding to the photomask film 21 as shown in Fig. 21. Moreover, the tin plated layer is partly exposed in the opening 22 for the via-hole.
(10) The board provided with the opening 22 is immersed in chromic acid for 19 minutes to dissolve and remove the epoxy resin particles existing on the surface of the interlaminar resin insulating layer 19 to thereby roughen the surface of the interlaminar resin insulating layer 19, whereby the roughened surfaces 23, 24 are formed as shown in Fig. 22. Thereafter, it is immersed in a neutral solution (made by Shipley) and washed with water.
Furthermore, a palladium catalyst (made by Atotech) is applied to the surface of the board subjected to the roughening treatment (roughened depth: 6 µm) to give a catalyst nucleus to the surface 23 of the interlaminar resin insulating layer 19 and the inner wall face 24 of the opening for the via-hole.
(11) The thus formed wiring board is immersed in an electroless copper plating aqueous solution having the following composition to form an electroless copper plated film 25 of 0.6 µm over a whole of the roughened surface as shown in Fig. 23.
[Electroless plating aqueous solution]

| | |
|---|---|
| EDTA | 50 g/L |
| Copper sulfate | 10 g/L |
| HCHO | 8 mL/L |
| NaOH | 10 g/L |
| α,α'-bipyridyl | 80 mg/L |
| PEG | 0.1 g/L |

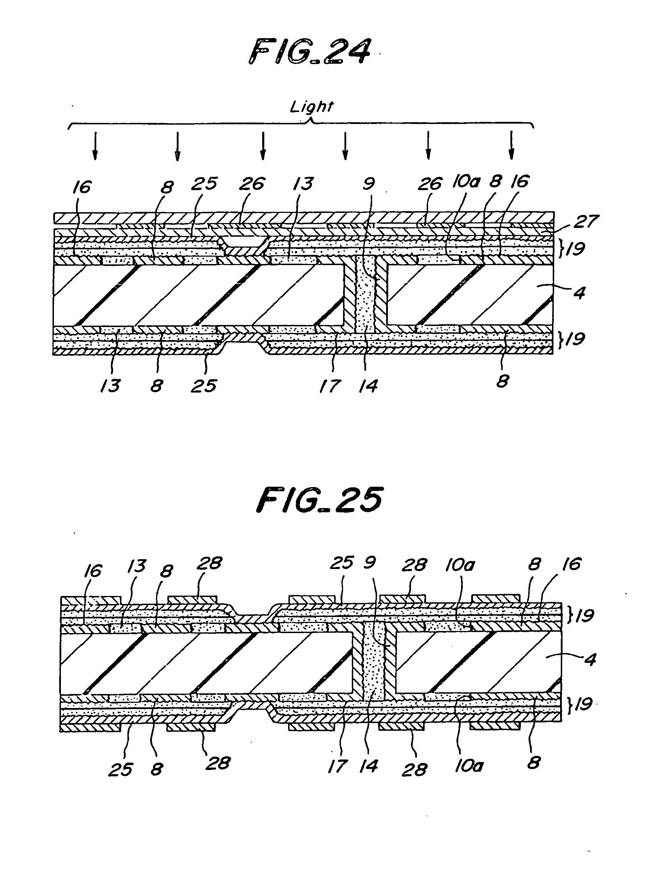

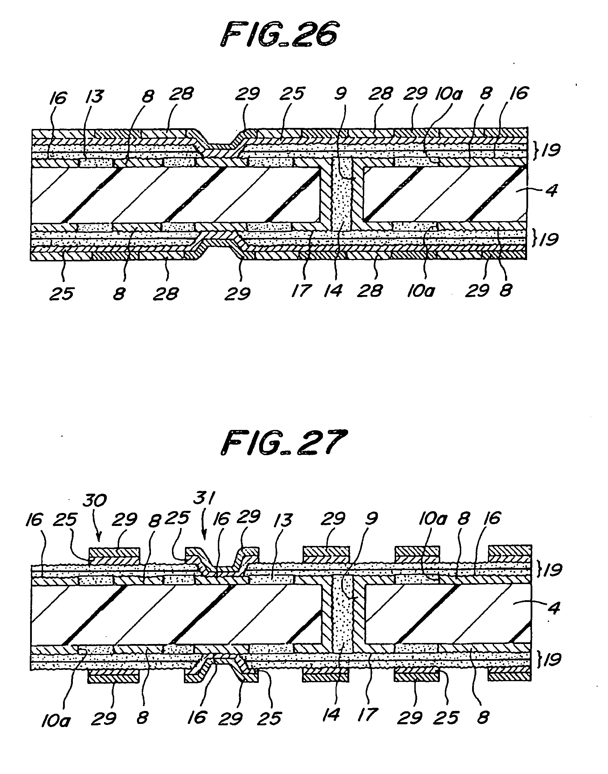

[Electroless plating conditions]
Liquid temperature of 70°C, 30 minutes
(12) As shown in Fig. 24, a commercially available photosensitive dry film 27 depicted with black circles 26 is attached to the electroless copper plated film 25 formed in the item (11) and a mask is placed thereon, which is exposed to a light at 100 mJ/cm2 and developed with 0.8% sodium carbonate to form plating resists 28 of 15 µm in thickness as shown in Fig. 25.
(13) Then, portions not forming the plating resist are subjected to an electrolytic copper plating under the following conditions to form an electrolytic copper plated film 29 of 15 µm in thickness as shown in Fig. 26.

| [Electrolytic plating aqueous solution] | |
|---|---|
| Sulfuric acid | 180 g/L |
| Copper sulfate | 80 g/L |
| Additive (Kaparasid GL, trade name, made by Atotech Japan) | 1 mL/L |

| [Electrolytic plating conditions] | |
|---|---|
| Current density | 1 A/dm² |
| Time | 30 minutes |
| Temperature | room temperature |

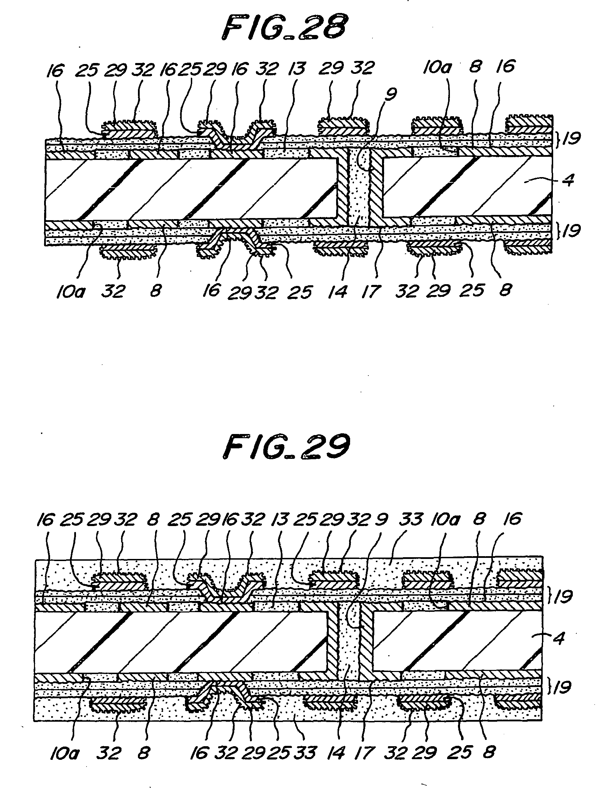

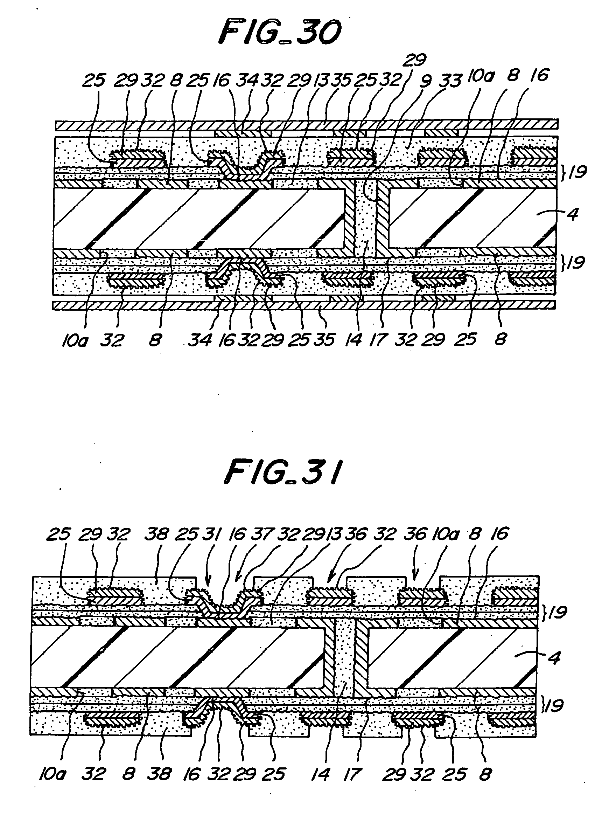

(14) After the plating resist 28 is peeled and removed with 5% KOH, the electroless plated film 25 beneath the plating resist 28 is dissolved and removed by etching with a mixed solution of sulfuric acid and hydrogen peroxide to from conductor circuits 30 of 18 µm in thickness comprised of the electroless copper plated film 25 and the electrolytic copper plated film 29 (including via-hole 31) as shown in Fig. 27.
(15) The same treatment as in the item (6) is carried out to form a roughened surface of Cu-Ni-P needle-shaped alloy and further the surface thereof is subjected to Sn substitution.
(16) The steps of the items (7)~(15) are repeated to form upperlayer conductor circuits, whereby a multilayer wiring board is obtained.
(17) As shown in Fig. 28, roughened surfaces 32 having a thickness of 3 µm are formed by etching the conductor circuits as a surface layer with an etching solution containing 10 parts by weight of imidazole copper(II) complex, 7 parts by weight of glycolic acid and 5 parts by weight of potassium chloride, "Mechetchbond", trade name, made by Mech Corporation under spraying through transferring rolls. The tin substitution is not applied to the roughened surface.
When the roughened surface is observed just above by means of an electron scanning microscope (x 5000), it has been confirmed that anchor portions 1 as shown in Figs. 4~8 are 11 on average, recess portions are 11 on average and the number of the ridge lines is 22 on average.
(18) A composition for solder resist is obtained by mixing 46.67 g of a photosensitizing oligomer (molecular weight: 4000) wherein 50% of epoxy group of 60% by weight of cresol novolac type epoxy resin (made by Nippon Kayaku Co., Ltd.) dissolved in DMDG, 15.0 g of 80% by weight of bisphenol A-type epoxy resin (Epikote 1001, trade name, made by Yuka Shell Co., Ltd.) dissolved in methyl ethyl ketone, 1.6 g of an imidazole curing agent (made by Shikoku Kasei Co., Ltd. 2E4MZ-CN), 3 g of a polyvalent acrylic monomer as a photosensitive monomer, 1.5 g of polyvalent acrylic monomer (made by Kyoeisha Kagaku Co., Ltd. DPE6A) and 0.71 g of a dispersion anti-foaming agent (made by Sannopuco Co., Ltd. S-65) and adding 2 g of benzophenone (made by Kanto Kagaku Co., Ltd.) as a photoinitiator and 0.2 g of Michler ketone (made by Kanto Kagaku Co., Ltd.) as a photosensitizer to the resulting mixture to adjust the viscosity to 2.0 Pa·s at 25°C. Moreover, the viscosity is measured by B-type viscometer using rotor No. 4 at 60 rpm and rotor No. 3 at 6 rpm.
(19) As shown in Fig. 29, the composition 33 for solder resist is applied at a thickness of 20 µm to both surfaces of the multilayer wiring board obtained in the item (16). After the drying treatment at 70°C for 20 minutes and 70°C for 30 minutes, a photomask film 35 of 5 mm in thickness depicted with a circle pattern (mask pattern) 34 is placed thereonto, exposed to a ultraviolet ray at 1000 mJ/cm² and developed with DMDG as shown in Fig. 30. Then, it is subjected to a heating treatment at 80°C for 1 hour, 100°C for 1 hour, 120°C for 1 hour and 150°C for 3 hours to form a solder resist layer 38 (thickness: 20 µm) opened (opening diameter: 200 µm) to a solder pad portion 36 (including a via-hole and its land portion 37) as shown in Fig. 31, whereby a printed wiring board is produced.
(20) Then, the board provided with the solder resist layer 38 is immersed in an electroless nickel plating solution of pH = 5 containing 30 g/L of nickel chloride, 10 g/L of sodium hypophosphite and 10 g/L of sodium citrate for 20 minutes to form a nickel plated layer 40 of 5 µm in thickness on the opening portions 36, 37 as shown in Fig. 32. Further, the board is immersed in an electroless gold plating solution containing 2 g/L of potassium gold cyanide, 75 g/L of ammonium chloride, 50 g/L of sodium citrate and 10 g/L of sodium hypophosphite at 93°C for 23 seconds to form a gold plated layer 41 of 0.03 µm on the nickel plated layer 40.
(21) Thereafter, a solder paste is printed on the opening portion of the solder resist layer 38 and reflowed at 200°C to form solder bumps (solder body) 42, whereby a printed wiring board 43 having the solder bumps 42 is produced. In this printed wiring board are disposed usual wiring portion (line width: 75 µm) and fine wiring portion (line width: 50 µm), and further the fine wiring portion is divided into portions having a coarse wiring density (distance: 400 µm) and portions having a dense wiring density (distance: 50 µm).

### Example 2

Fig. 33 is a diagrammatically section view of a printed wiring board 44. In this example, the production steps are fundamentally the same as in Example 1, except that the roughened surface in the surface layer conductor circuits (conductor circuits for solder pad) is covered with a metal layer 51 as shown in Figs. 9~12 at the step (17). As the metal, nickel is used, which is applied by an electroless plating. The thus formed nickel layer has a thickness of 0.04 µm.

In this example, the solder bumps (solder body) 54 are formed on the opening portions of the solder resist layer 38 through the nickel plated layer 52 on the nickel layer 51 and the gold plated layer 53 thereon as shown in Fig. 33 at the steps (18)~(21).

### Example 3

This example is fundamentally the same as in Example 2 except that tin layer through substitution plating is used instead of the nickel layer through the electroless plating as a metal layer covering the roughened surface of the conductor circuits for solder pad. This tin layer has a thickness of 0.03 µm.

### Example 4

This example is fundamentally the same as in Example 2 except that zinc layer through electroless plating is used instead of the nickel layer through the electroless plating as a metal layer covering the roughened surface of the conductor circuits for solder pad. This zinc layer has a thickness of 0.05 µm.

### Example 5

This example is fundamentally the same as in Example 2 except that a metal layer through vapor deposition is used instead of the nickel layer through the electroless plating as a metal layer covering the roughened surface of the conductor circuits for solder pad. This metal layer is made of iron and cobalt and has a thickness of 0.05 µm.

### Example 6

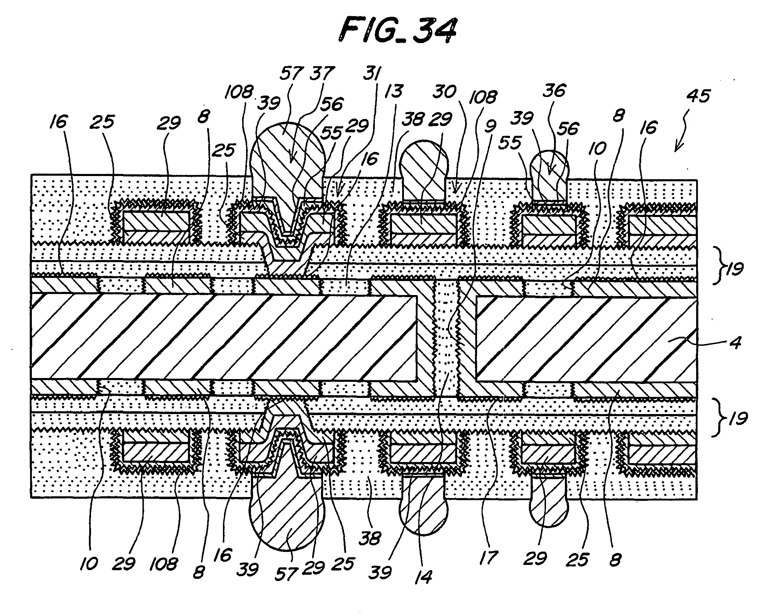

After the steps (1)~(14) of Example 1, a printed wiring board 45 shown in Fig. 34 is produced through the following steps.
(22) A multilayer wiring board is obtained by repeating the steps (6)~(14) of Example 1 to further form upperlayer conductor circuits. The innerlayer conductor circuits formed through these steps are not shown in the drawing. Moreover, the conductor circuits for solder pad in an outermost layer of the printed wiring board in Fig. 34 are shown by the conductor circuits (conductor circuits for solder pad) 30, 31 formed at the step (14) of Example 1.
(23) The printed wiring board provided with the conductor circuits as the surface layer is degreased with an alkali, soft etched and treated with a catalyst solution containing palladium chloride and an organic acid to give a Pd catalyst. After the activation of this catalyst, it is immersed in an electroless plating solution of pH = 9 containing 3.2 x 10⁻² mol/L of copper sulfate, 3.9 x 10⁻³ mol/L of nickel sulfate, 5.4 x 10-2 mol/L of sodium citrate, 3.3 x 10⁻¹ mol/L of sodium hypophosphite and 1.1 X 10⁻⁴mol/L of a surfactant (Surfeel 465, trade name, made by Nisshin Kagaku Kogyo Co., Ltd.). After 1 minute of the immersion, it is vibrated and rocked 1 times per 4 seconds to form a roughened layer 39 of Cu-Ni-P needle-shaped alloy on the surfaces of the conductor circuits 30, 31.
(24) Then, a rust proof layer 108 is formed on the roughened layer 39. As an anti-rust agent is used 1,2,3-benzotriazole. The roughened layer 39 is immersed in a solution containing 15% by weight of such an anti-rust agent at a temperature of 45°C for 1 minute and washed with water to form the rust proof layer 108 on the roughened layer 39.
(25) Thereafter, the printed wring board is produced by forming the solder resist layer 38 (thickness: 20 µm) opened (opening diameter: 200 µm) in the solder pad portion 36 (including via-hole and its land portion 37) as shown in Fig. 34 according to the steps (18) and (19) of Example 1.
   Moreover, the anti-rust agent and the residual component of the solder resist layer in the opening portion are removed by an oxygen plasma (plasma cleaning device, Model PC12F-G, made by Kyushu Matsushita Co., Ltd.). After the printed wiring board is placed at a vacuum state, such a plasma treatment is carried out at a plasma discharging quantity of 1000 W, an oxygen feeding pressure of 0.4 MPa, an oxygen feeding rate of 500 sec/M and a treating time of 2 minutes.
(26) Then, the thus plasma treated board is treated according to the steps (20) and (21) of Example 1 to form nickel plated layer 55 and electroless gold plated layer 56 on the opening portions 36, 37 as shown in Fig. 34, whereby the printed wiring board 45 having solder bumps 57 is produced.
(27) The printed wiring board is divided and cut into a proper size by a device having a router, which is passed through a checking step for inspecting short-circuit and wire breakage of the printed wiring board to obtain a desired printed wiring board. Moreover, a plasma treatment with oxygen, carbon tetrachloride or the like may properly be added at a letter-printing step for forming product recognition letters and the like or in order to improve the equality of the solder resist layer.
(28) Thereafter, the solder bumps of the multilayer printed wiring board are positioned to respective bumps of an IC chip with a target mark of the board by means of a proper fastening device and then the solder bumps are reflowed to bond the solder bump to the bump. Next, an under fill resin is filled between the IC chip and the printed wiring board to obtain the printed wiring board connected to the IC chip.

### Example 7

This example is fundamentally the same as in Example 6 except that the formation of the roughened surface is carried out by etching with an etching solution containing 10 parts by weight of imidazole copper(II) complex, 7 parts by weight of glycolic acid and 5 parts by weight of potassium chloride, i.e. "Mechetchbond", trade name, made by Mech Corporation under spraying while transferring through rolls to obtain a roughened surface having a thickness of 3 µm. Thereafter, the rust proof layer is formed on the roughened surface by spraying the same anti-rust agent as in Example 6 at room temperature.

### Example 8

This example is fundamentally the same as in Example 6 except that the roughened surface having a maximum height of 3 µm is formed by graphitization-reduction treatment using NaOH (10 g/L), NaClO₂ (40 g/L) and Na₃PO₄ (6 g/L) as an oxidation bath (graphitization bath) and NaOH (10 g/L) and NaBH₄ (6 g/L) as a reduction bath. Thereafter, a rust proof layer is formed on the roughened surface by applying a solution of 10% by weight of tollyltriazole as an anti-rust agent to both surfaces through a roll coater.

### Example 9

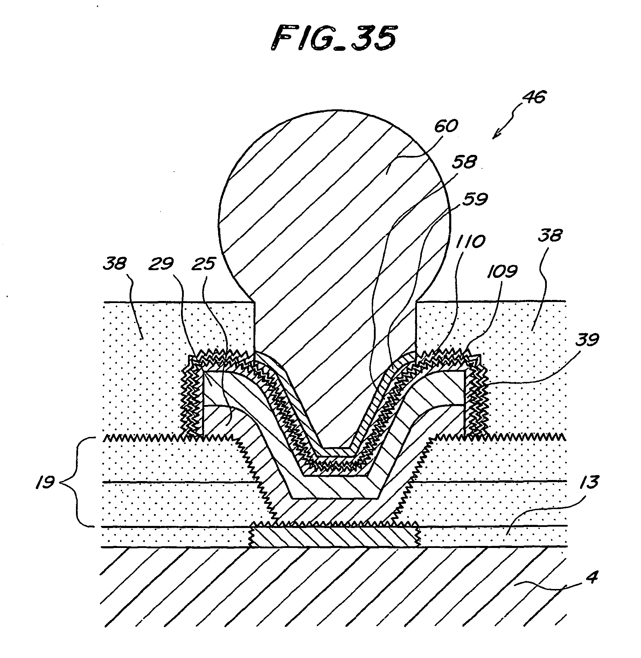

Fig. 35 is a partial section view of a printed wiring board 46 in this example. This board is produced in the same manner as in Example 6 except that tin layer 109 having a thickness of 0.03 µm is formed by substitution plating after the formation of the roughened layer 39 and then a rust proof layer 110 is formed on the tin layer 109 by immersing the tin layer 109 of the conductor circuit for solder pad in a solution containing 10% by weight of tollyltriazole as an anti-rust agent at a temperature of 50°C for 1 minute.

### Example 10

This example is fundamentally the same as in Example 6 except that the roughened surface having a maximum height of 3 µm is formed by etching with an etching solution containing 10 parts by weight of imidazole copper(II) complex, 7 parts by weight of glycolic acid and 5 parts by weight of potassium chloride, i.e. "Mechetchbond", trade name, made by Mech Corporation under spraying while transferring through rolls. A nickel layer having a thickness of 0.04 µm is formed on the roughened surface by electroless plating. Thereafter, a rust proof layer is formed on the roughened surface by immersing the nickel layer in a solution containing 5% by weight of 1,2,3-benzotriazole and 5% by weight of tollyltriazole as an anti-rust agent at a temperature of 55°C for 45 seconds.

### Example 11

This example is fundamentally the same as in Example 6 except that the roughened surface having a maximum height of 3 µm is formed by graphitization-reduction treatment using NaOH (10 g/L), NaClO₂ (40 g/L) and Na₃PO₄ (6 g/L) as an oxidation bath (graphitization bath) and NaOH (10 g/L) and NaBH₄ (6 g/L) as a reduction bath. Then, zinc layer having a thickness of 0.05 µm is formed on the resulting roughened surface by sputtering and a rust proof layer is formed thereon by spraying a solution containing 5% by weight of 1,2,3-benzotriazole and 5% by weight of tollyltriazole as an anti-rust agent onto the zinc layer at room temperature.

### Comparative Examples 1. 2

These examples are fundamentally the same as in Example 1. However, in Comparative Example 1, the roughened surface is formed on the conductor circuit as a surface layer by graphitization-reduction treatment using NaOH (10 g/L), NaClO₂ (40 g/L) and Na₃PO₄ (6 g/L) as an oxidation bath (graphitization bath) and NaOH (10 g/L) and NaBH₄ (6 g/L) as a reduction bath, while in Comparative Example 2, the roughened layer made of copper-nickel-phosphorus needle-shaped alloy is formed on the conductor circuit as a surface layer by using an electroless plating solution of pH = 9 containing 3.2 x 10⁻² mol/L of copper sulfate, 3.9 x 10⁻³ mol/L of nickel sulfate, 5.4 × 10⁻² mol/L of a complexing agent, 3.3 x 10⁻¹ mol/L of sodium hypophosphite and 1.1 x 10⁻⁴ mol/L of a surfactant (Surfeel 465, trade name, made by Nisshin Kagaku Kogyo Co., Ltd.). In the printed wiring boards of Comparative Examples 1 and 2, usual wiring portions and fine wiring portions as well as coarse wiring density portion and dense wiring density portion are formed likewise Example 1.

### Comparative Example 3

This example is fundamentally the same as in Example 2 except that the roughened surface is formed on the conductor circuit as a surface layer by graphitization-reduction treatment using NaOH (10 g/L), NaClO₂ (40 g/L) and Na₃PO₄ (6 g/L) as an oxidation bath (graphitization bath) and NaOH (10 g/L) and NaBH₄ (6 g/L) as a reduction bath. In this example, usual wiring portions and fine wiring portions as well as coarse wiring density portion and dense wiring density portion are formed likewise Example 1.

### Comparative Example 4

This example is fundamentally the same as in Example 2 except that the roughened layer made of copper-nickel-phosphorus needle-shaped alloy is formed on the conductor circuit as a surface layer by using an electroless plating solution of pH = 9 containing 3.2 x 10⁻² mol/L of copper sulfate, 3.9 x 10⁻³ mol/L of nickel sulfate, 5.4 x 10⁻² mol/L of a complexing agent, 3.3 x 10⁻¹ mol/L of sodium hypophosphite and 1.1 x 10⁻⁴ mol/L of a surfactant (Surfeel 465, trade name, made by Nisshin Kagaku Kogyo Co., Ltd.). In this example, usual wiring portions and fine wiring portions as well as coarse wiring density portion and dense wiring density portion are formed likewise Example 1.

### Comparative Example 5

This example is fundamentally the same as in Example 6 except that the anti-rust agent is not applied to the roughened surface.

### Comparative Example 6

This example is fundamentally the same as in Example 7 except that the roughened surface having a maximum height of 3 µm is formed by etching with an etching solution containing 10 parts by weight of imidazole copper(II) complex, 7 parts by weight of glycolic acid and 5 parts by weight of potassium chloride, i.e. "Mechetchbond", trade name, made by Mech Corporation under spraying while transferring through rolls and the anti-rust agent is not applied to the roughened surface.

### Peeling test of solder resist layer

With respect to the printed wiring boards produced in Example 1 and Comparative Examples 1 and 2, the peeling test of solder resist layer is carried out after the formation of the solder resist layer and after a reliability test (under heat cycle condition). Moreover, the presence of bad continuity between conductor circuits is compared between the coarse and dense wiring density portions and also organic residue at the bottom of the opening portion is measured. The results are shown in Table 1.

**Table 1**

| Evaluation terms | Evaluating portion | Example 1 | Comparative Example 1 | Comparative Example 2 |
|---|---|---|---|---|
| Peeling after the formation of solder resist layer * 1 | wiring density - coarse | none | none | none |
| | wiring density-dense | none | none | none |
| Peeling after heat cycle test *2 | wiring density - coarse | none | none | none |
| | wiring density-dense | none | none | none |
| Bad continuity between conductor circuits * 1 | wiring density - coarse | none | none | none |
| | wiring density-dense | none | none | presence |
| Organic residue *3 | bottom of via-hole | none | none | presence |

| | | | | |
|---|---|---|---|---|
| *1: observed by means of a microscope (x 50). *2: heat cycle test of +120°C and -20°C is repeated for 100 hours. Thereafter, the solder resist layer is observed by means of a microscope (x 50). *3: observed by means of an electron scanning microscope (x 5000). | | | | |

As shown in Table 1, in the printed wiring board of Example 1, there are not caused the peeling of the solder resist layer and the occurrence of bad continuity between the conductor circuits, and the organic residue is not observed. In the printed wiring board of Comparative Example 1, the peeling is caused in the coarse wiring density portion after the heat cycle test, while in the printed wiring board of Comparative Example 2, the bad continuity between the conductor circuits is caused and the organic residue is observed at the bottom of the opening portion.

### Peeling tests of solder resist later and solder bump

With respect to the printed wiring boards produced in Examples 2~5 and Comparative Examples 3 and 4, the peeling, cracking and the like of the solder resist layer and the solder bump are inspected after the formation of the solder bump and after the reliability test (under heat cycle condition), and the shear strength of the solder bump is measured, and the continuity test through a checker is carried out to judge the presence of wiring breakage and short-circuit. The results are shown in Table 2.

**Table 2**

| Items | Evaluation items | Judgment | Example | | | | Comparative Example | |
|---|---|---|---|---|---|---|---|---|
| | | | 2 | 3 | 4 | 5 | 3 | 4 |
| After the formation of solder bump | solder resist state | presence of peeling *2 | none | none | none | none | presence | none |
| | peeling of solder bump | presence of peeling and cracking *2 | none | none | none | none | none | none |
| | continuity test | monitor result *3 | good | good | good | good | good | bad |
| | shear strength of solder bump | shear strength [kgf/cm²] *4 | 2.00 | 2.00 | 2.00 | 2.00 | 1.60 | 2.00 |
| After reliability test *1 | solder resist state | presence of peeling *2 | none | none | none | none | none | none |
| | peeling of solder bump | presence of peeling and cracking *2 | none | none | none | none | none | presence |
| | continuity test | monitor result | good | good | good | good | bad | bad |
| | shear strength of solder bump | shear strength [kgf/cm²] *4 | 1.90 | 1.90 | 1.90 | 1.90 | 1.50 | 1.60 |

| | | | | | | | | |
|---|---|---|---|---|---|---|---|---|
| *1: measured after the heat cycle (135°C for 3 minutes and -65°C for 3 minutes in a liquid tank) is repeated 1000 cycles. *2: a cut section is observed by means of a microscope (x 50). ^{*}3: confirmed continuity between solder bump and BGA pad. good in the case that value of contact resistance is not more than 1 µΩ, bad in the case that value of contact resistance exceeds 1 µΩ *4: when a top of a pull tester is attached to the solder bump and pulled up vertically, a numerical value of the pull tester is read at a time of taking out the solder bump. | | | | | | | | |

As shown in Table 2, in the printed wiring boards of Examples 2~5, no peeling and cracking of the solder resist layer and the solder bump is caused and the continuity and shear strength of solder bump are excellent as compared with the printed wiring boards of Comparative Examples 3 and 4. And also, the strength between the solder resist layer and the solder bump is sufficiently maintained and the wiring breakage and short-circuit are not caused even after the reliability test.

Further, with respect to the printed wiring boards produced in Examples 6~11 and Comparative Examples 5 and 6, the peeling, cracking and the like of the solder resist layer and the solder bump are inspected after the formation of the solder bump and after the reliability test (under heat cycle condition), and the shear strength of the solder bump is measured, and the continuity test through a checker is carried out to judge the presence of wiring breakage and short-circuit. The results are shown in Tables 3 and 4.

**Table 3**

| Items | Evaluation items | Judgment | Example | | | |
|---|---|---|---|---|---|---|
| | | | 6 | 7 | 8 | 9 |
| After the formation of solder bump | solder resist state | presence of peeling *2 | none | none | none | none |
| | peeling of solder bump | presence of peeling and cracking *2 | none | none | none | none |
| | continuity test | monitor result *3 | good | good | good | good |
| | shear strength of solder bump | shear strength [kgf/cm²] *4 | 1.96 | 1.99 | 2.06 | 2.15 |
| After reliability test *1 | solder resist state | presence of peeling *2 | none | none | none | none |
| | peeling of solder bump | presence of peeling and cracking *2 | none | none | none | none |
| | continuity test | monitor result *3 | good | good | good | good |
| | shear strength of solder bump | shear strength [kgf/cm²] *4 | 1.97 | 1.95 | 2.05 | 2.15 |

| | | | | | | |
|---|---|---|---|---|---|---|
| *1: measured after the heat cycle (135°C for 3 minutes and -65°C for 3 minutes in a liquid tank) is repeated 1000 cycles. *2: a cut section is observed by means of a microscope (x 50). *3: confirmed continuity between solder bump and BGA pad. good in the case that value of contact resistance is not more than 1 µΩ, bad in the case that value of contact resistance exceeds 1 µΩ *4: when a top of a pull tester is attached to the solder bump and pulled up vertically, a numerical value of the pull tester is read at a time of taking out the solder bump. | | | | | | |

**Table 4**

| Items | Evaluation items | Judgment | Example | | Comparative Example | |
|---|---|---|---|---|---|---|
| | | | 10 | 11 | 5 | 6 |
| After the formation of solder bump | solder resist | presence of state peeling *2 | none | none | presence | none |
| | peeling of solder bump | presence of peeling and cracking *2 | none | none | none | none |
| | continuity test | monitor result *3 | good | good | good | bad |
| | shear strength of solder bump | shear strength [kgf/cm²] *4 | 2.15 | 2.08 | 1.32 | 1.41 |
| After reliability test *1 | solder resist state | presence of peeling *2 | none | none | none | none |
| | peeling of solder bump | presence of peeling and cracking *2 | none | none | none | presence |
| | continuity test | monitor result *3 | good | good | bad | bad |
| | shear strength of solder bump | shear strength [kgf/cm²] *4 | 2.15 | 2.06 | 1.28 | 1.37 |

| | | | | | | |
|---|---|---|---|---|---|---|
| *1: measured after the heat cycle (135°C for 3 minutes and -65°C for 3 minutes in a liquid tank) is repeated 1000 cycles. *2: a cut section is observed by means of a microscope (x 50). *3: confirmed continuity between solder bump and BGA pad. good in the case that value of contact resistance is not more than 1 µΩ, bad in the case that value of contact resistance exceeds 1 µΩ *4: when a top of a pull tester is attached to the solder bump and pulled up vertically, a numerical value of the pull tester is read at a time of taking out the solder bump. | | | | | | |

When the opening portion of the solder resist layer is observed by means of a microscope (x 50), the resin residue is observed in the printed wiring boards of the comparative examples, while the resin residue is not observed in the printed wiring boards of the examples. Further, as shown in Tables 3 and 4, in the printed wiring boards of Examples 6~11, no peeling and cracking of the solder resist layer and the solder bump is caused and the continuity and shear strength of solder bump are excellent as compared with the printed wiring boards of Comparative Examples 5 and 6. And also, the strength between the solder resist layer and the solder bump is sufficiently maintained and the wiring breakage and short-circuit are not caused even after the reliability test.

### INDUSTRIAL APPLICABILITY

As mentioned above, in the printed wiring board according to the invention, the roughened surface having a given shape is formed on the surface of the conductor circuit for solder pad and the solder resist layer is strongly adhered thereto through the roughened surface, so that the sufficient adhesion property between the conductor circuit and the solder resist layer can be ensured when the solder resist layer is removed in portions forming the solder bumps to decrease the contact area between the conductor circuit and the solder resist layer or even when the conductor circuit is comprised of fine wiring and the wiring density is coarse.

In the printed wiring board according to the invention, the residue of the solder resist forming resin is not left on the roughened surface exposing to the opening portion for the formation of the solder bump, so that the adhesion property to the metal beneath the solder bump is excellent and the bad continuity is not caused in the portions forming the solder bumps.

And also, in the printed wiring board according to the invention, the shape and strength having excellent adhesion properties to the solder resist layer and to the metal beneath the solder bump are held by covering the roughened surface of the conductor circuit for solder pad with the metal layer, so that the strength of the solder bump is considerably increased and the dropping off of the solder bump can be prevented.

Further, in the printed wiring board according to the invention, the roughened surface of the conductor circuit for solder pad is protected with the rust proof layer to prevent the deterioration of the conductor circuit for solder pad and to maintain the shape of the roughened surface having excellent adhesion properties to the solder resist layer and to the solder pad, so that when the conductor circuits for solder pad are finely wired and formed at a coarse wiring density, the adhesion property between the conductor circuit and the solder resist layer is enhanced, and even when the portions forming the solder bumps are exposed to a high temperature or a high pressure, the bad continuity is not caused in the solder bump forming portions because the conductor circuit is strongly adhered to the solder resist layer without peeling.

Moreover, in the printed wiring board according to the invention, the roughened surface of the conductor circuit for solder pad is covered with the metal layer for rust proof layer made of a given metal and protected with the rust proof layer, so that even when a part of the solder resist layer is opened so as to form a solder pad, the surface of the conductor circuit for solder pad maintains the shape having an excellent adhesion property to the solder pad and the resin for the solder resist layer is not left in the opening portion and hence the adhesion properties and strengths between the conductor circuit for solder pad and the solder resist layer and between the conductor circuit and the solder pad are improved and the solder bump having an excellent adhesion property to the metal beneath the solder bump is formed.

## Claims

1. A method of producing a printed wiring board comprising conductor circuits for solder pads, fine wirings each having a line width of not more than 50 µm, a solder resist layer formed on the conductor circuits for solder pads and the fine wirings, and an opening portion formed in the solder resist layer for disposing a solder body, which comprises the steps of:
(a) forming a roughened surface on the conductor circuits for solder pads and the fine wirings by treating with an etching solution containing a copper II complex and an organic acid;
(b) forming the solder resist layer on the conductor circuits for solder pads and the fine wirings;
(c) forming the opening portion for exposing the conductor circuit for solder pad in the solder resist layer;
(d) removing a resin included in the solder resist layer on the conductor circuit for solder pad in the opening portion; and
(e) forming a solder bump on the conductor circuit for solder pad in the opening portion.

2. A method of producing a printed wiring board according to claim 1, wherein the conductor circuit for solder pad and the fine wiring comprises an electroless plated film and an electrolytic plated film formed thereon.

3. A method of producing a printed wiring board according to claim 1, wherein the opening portion includes a via-hole and its land portion.

4. A method of producing a printed wiring board according to claim 1, further comprising forming a gold plated layer on the opening portion.

5. A method of producing a printed wiring board according to claim 1, wherein the roughened surface is formed by treating under an oxygen existing condition.

## Patentansprüche

1. Verfahren zur Herstellung einer gedruckten Leiterbahnplatine, die Leiterbahnschaltungen für Lötaugen, dünne Leitungsführungen, die jeweils eine Leiterbahnbreite von nicht mehr als 50 µm aufweisen, eine auf den Leiterbahnschaltungen für Lötaugen und den dünnen Leitungsführungen ausgeformte Lötstopplackschicht, und einen zur Anordnung eines Lotkörpers in der Lötstopplackschicht ausgeformten Öffnungsteilbereich aufweist, wobei das Verfahren die Schritte aufweist:
(a) Ausformen einer aufgerauten Oberfläche auf den Leiterbahnschaltungen für Lötaugen und den dünnen Leitungsführungen durch Behandlung mit einer ätzenden Lösung die einen Kupfer II Komplex und eine organische Säure enthält;
(b) Ausformen der Lötstopplackschicht auf den Leiterbahnschaltungen für Lötaugen und den dünnen Leitungsführungen;
(c) Ausformen des Öffnungsteilbereichs zum Freilegen der Leiterbahnschaltung für das Lötauge in der Lötstopplackschicht;
(d) Entfernen eines Harzes, das in der Lötstopplackschicht auf der Leiterbahnschaltung für das Lötauge enthalten ist in dem Öffnungsteilbereich, und
(e) Ausformen einer Lotperle auf der Leiterbahnschaltung für das Lötauge in dem Öffnungsteilbereich.

2. Verfahren zur Herstellung einer gedruckten Leiterbahnplatine gemäß Anspruch 1, wobei die Leiterbahnschaltung für das Lötauge und die dünne Leitungsführung eine darauf ausgeformte stromlos aufgebrachte Schicht und eine elektrolytisch aufgebrachte Schicht aufweist.

3. Verfahren zur Herstellung einer gedruckten Leiterbahnplatine gemäß Anspruch 1, wobei der Öffnungsteilbereich ein Durchgangsloch und dessen Anschlussflächenteil aufweist.

4. Verfahren zur Herstellung einer gedruckten Leiterbahnplatine gemäß Anspruch 1, das weiterhin das Ausformen einer vergoldeten Schicht auf dem Öffnungsteilbereich aufweist.

5. Verfahren zur Herstellung einer gedruckten Leiterbahnplatine gemäß Anspruch 1, wobei die aufgeraute Oberfläche durch Bearbeitung unter einem Zustand mit vorhandenem Sauerstoff ausgeformt wird.

## Revendications

1. Procédé de fabrication d'un tableau de connexions imprimé comprenant des circuits conducteurs pour pastilles de brasage, des connexions fines ayant chacune une largeur de ligne ne dépassant pas 50 µm, une couche d'épargne de brasure formée sur les circuits conducteurs pour pastilles de brasage et les connexions fines, et une partie d'ouverture formée dans la couche d'épargne de brasure pour disposer un corps de brasure, qui comprend les étapes consistant à :
(a) former une surface rugosifiée sur les circuits conducteurs pour pastilles de brasage et les connexions fines en traitant à l'aide d'une solution de gravure contenant un complexe de cuivre II et un acide organique ;
(b) former la couche d'épargne de brasure sur les circuits conducteurs pour pastilles de brasage et les connexions fines ;
(c) former la partie d'ouverture pour exposer le circuit conducteur pour pastille de brasage dans la couche d'épargne de brasure ;
(d) retirer une résine incluse dans la couche d'épargne de brasure sur le circuit conducteur pour pastille de brasage dans la partie d'ouverture ; et
(e) former une bosse de brasure sur le circuit conducteur pour pastille de brasage dans la partie d'ouverture.

2. Procédé de fabrication d'un tableau de connexions imprimé selon la revendication 1, dans lequel le circuit conducteur pour pastille de brasage et la connexion fine comprend un film à placage anélectrolytique et un film à placage électrolytique formés sur celui-ci.

3. Procédé de fabrication d'un tableau de connexions imprimé selon la revendication 1, dans lequel la partie d'ouverture comporte un trou d'interconnexion et sa partie de plage d'accueil.

4. Procédé de fabrication d'un tableau de connexions imprimé selon la revendication 1, comprenant en outre le fait de former une couche plaquée or sur la partie d'ouverture.

5. Procédé de fabrication d'un tableau de connexions imprimé selon la revendication 1, dans lequel la surface rugosifiée est formée en traitant sous une condition en présence d'oxygène.
